# EUROPEAN PATENT SPECIFICATION

(11) **EP 1 085 751 B1**
(45) Date of publication and mention of the grant of the patent: **14.11.2012**
(21) Application number: 00307869.8
(22) Date of filing: 12.09.2000
(51) Int. Cl.: H04N 5/232, H04N 5/369

(54) **Image pickup apparatus**
Bildaufnahmegerät
Appareil de prise d'image

(30) Priority: 13.09.1999 JP 25892199
(43) Date of publication of application: 21.03.2001
(73) Proprietor: CANON KABUSHIKI KAISHA, Tokyo (JP)
(72) Inventor: Suda, Yasuo, Ohta-ku, Tokyo (JP)
(74) Representative: TBK

(56) References cited:
- EP-A- 0 757 476
- JP-A- 1 216 306
- US-A- 4 373 791
- US-A- 4 859 842
- US-A- 5 485 004

## Description

The present invention relates to an image pickup apparatus employing a solid-state image sensor, adapted for use for example in a digital colour camera or a video movie camera.

In a digital colour camera, in response to the depression of a shutter release button, a solid-state image sensor such as a CCD sensor or a CMOS sensor is exposed to the image of an object field for a predetermined period, and an image signal thus obtained and representing a still image is converted into a digital signal which is then subjected to a predetermined process such as a YC process to obtain an image signal of a predetermined format. The digital image signal representing the picked-up image is respectively stored in a semiconductor memory. The recorded image signal is read out any time and reproduced into a signal suitable for display or printing and is outputted for example to a monitor for display.

The conventional digital colour camera utilizes the image pickup apparatus for focus detection, employing the contrast detection method. The focus adjustment by the contrast detection method consists of determining the sharpness of an object image, formed by the image pickup optical system, by evaluating the output of the solid-state image sensor with a predetermined function, and adjusting a position of the image pickup optical system on the axis in such a manner that the value of such function assumes an extreme value. The evaluating function can be, for example, the addition of the absolute differences between the adjacent luminance signals within the focus detecting areas, the addition of the squares of the absolute differences between the adjacent luminance signals within the focus detecting areas or a similar processing of the differences of the adjacent signals on each of the R, G and B pixel signals.

In general, the focus detection of such contrast detection method is associated with a drawback of requiring a considerable time for reaching the in-focus state, because the value of the evaluating function is determined for each slight movement of the image pickup optical system on the axis.

There is also known, as disclosed in the U.S. Patent No. 4,410,804, an image pickup apparatus incorporating a focus detecting device of so-called phase difference detection method, in which one or two pairs of light-receiving units are provided for each of microlenses arranged in a two-dimensional array, and the light-receiving units are projected by the microlens onto the pupil of the image pickup optical system, thereby dividing such pupil. In the phase difference detection method, the object images are respectively formed by two light beams passing through the different areas of the pupil of the image pickup optical system and the positional phase difference between the two object images is detected from the output of the image sensor and is converted into the defocus amount of the image pickup optical system.

The focus detection by the phase difference detection method, being capable of determining the defocus amount, has an advantage of significantly reducing the time required for reaching the in-focus state, in comparison with the contrast detection method.

However the solid-state image sensor of the structure disclosed in the U.S. Patent No. 4,410,804 provides an image of extremely low quality, in terms of the image pickup ability for the object image, since the image is formed by a pair or two pairs of light beams passing through a part of the pupil of the image pickup optical system. Such image results from an unnatural image blur caused by the non-centered light beams, particularly in the out-of-focus foreground or background of the image.

Japanese Patent Application JP-A-01-216306 discloses an image pickup apparatus which is arranged so as to function as a distance measurement element for focus detection by processing separately outputs of a pair of image pickup elements each arranged together with a plurality of micro-lenses, and also so as to function as an image pickup element by adding the outputs of the pair of image pickup elements.

Japanese Patent Application JP-A-04-267211 discloses an image pickup apparatus which is arranged so that a plurality of micro-lenses are arranged in a matrix form with each being shifted relative to a corresponding image pickup element and an output of the image pickup element whose corresponding micro-lens is shifted in one direction is compared with an output of the image pickup element whose corresponding micro lens is shifted in the other direction to detect a focusing state to drive a focus adjustment lens, while those outputs are added to generate an image pickup signal.

Japanese Patent Application JP-A-07-142692 discloses an image pickup apparatus having a plurality of pixels each of which includes transfer means for transferring a signal from a photoelectric conversion unit and amplification means for amplifying the signal transferred by the transfer means.

US Patent US 5,485,004 discloses a photosensor device including means for designating a plurality of pixel blocks of any desired size.

European Patent Application EP 0 757 476 A2 discloses a solid state image pickup apparatus which is provided in order to realize a multi-function sensor in which in a pixel portion an addition and a non-addition can be arbitrarily performed. In the thus disclosed solid state image pickup apparatus, charges generated by a photoelectric converting device are transferred to a floating diffusion portion through a transfer switch and a change in electric potential of the floating diffusion portion is outputted by a source-follower. Some photoelectric converting devices are connected to one floating diffusion portion through the transfer switch. One set of source-follower are formed for a few pixels. The photoelectric converting device is constructed by an MOS transistor gate and a depletion layer under the gate.

The present invention is intended to provide an image pickup apparatus capable of high-speed adjustment for image pickup and of forming a high quality image.

The present invention provides an image pickup apparatus as defined in claim 1.

Further developments and/or modifications of the image pickup apparatus of the present invention are defined in the dependent claims.

The aforesaid features of the present invention will become fully apparent from the following description, which is to be taken in conjunction with the accompanying drawings, wherein:
Fig. 1 is a view showing the configuration of an image pickup optical system;
Fig. 2 is a circuit diagram of an area sensor unit in an image sensor element 100;
Fig. 3 is a cross-sectional view of a light-receiving unit;
Fig. 4 is a schematic view showing an image pickup area and focus detection areas;
Fig. 5 is a plan view showing the arrangement of pixels and colour filters;
Fig. 6 is a plan view showing the positional relationship between microlenses and light-receiving units;
Fig. 7 is a perspective view showing the surface state of microlenses;
Fig. 8 is a cross-sectional view of the area sensor unit;
Figs. 9A and 9B are views respectively showing a light beam entering a first photoelectric conversion unit and that entering a second photoelectric conversion unit;
Fig. 10 is a view showing a light beam entering the second photoelectric conversion unit;
Fig. 11 is a chart showing the response characteristics of the image sensor element 100;
Fig. 12 is a view showing the pitch of pixels;
Fig. 13 is a block diagram showing the internal configuration of the image sensor element 100 including peripheral circuits thereof;
Fig. 14 is a view for explaining an output position designating command;
Figs. 15A, 15B, 15C and 15D are views for explaining the function of an electronic shutter, wherein Fig. 15A is a view showing a case of vertical line-sequential pixel readout, Fig. 15B is a timing chart in case the accumulation time is maintained substantially same, Fig. 15C is a timing chart in case the charge accumulation time is shortened for the entire image, and Fig. 15D is a timing chart in case the signal level of a second row is made different from that of other rows;
Fig. 16 is a timing chart showing a case of independently reading the signals of the first and second photoelectric conversion units;
Fig. 17 is a timing chart showing a case of adding the signals of the first and second photoelectric conversion units;
Fig. 18 is a magnified view of a focus detection area 61;
Fig. 19 is a chart showing image signals from light-receiving units 80-1, 80-3, ..., 80-11 provided with green color filters within a pixel column 82;
Fig. 20 is a chart showing image signals from light-receiving units 81-2, 81-4, ..., 81-12 provided with green color filters within a pixel column 83;
Fig. 21 is a chart showing image signals from light-receiving units 80-2, 80-4, ..., 80-12 provided with red color filters within a pixel column 82;
Fig. 22 is a chart showing image signals from light-receiving units 81-1, 81-3, ..., 81-11 provided with blue color filters within a pixel column 83;
Fig. 23 is a chart showing image signals from light-receiving units 80-1, 80-3, ..., 80-11 provided with green filters within a pixel column 82;
Fig. 24 is a chart showing image signals from light-receiving units 81-2, 81-4, ..., 81-12 provided with green color filters within a pixel column 83;
Fig. 25 is a chart showing image signals from light-receiving units 80-2, 80-4, ..., 80-12 provided with red color filters within a pixel column 82;
Fig. 26 is a chart showing image signals from light-receiving units 81-1, 81-3, ..., 81-11 provided with blue color filters within a pixel column 83;
Fig. 27 is a perspective view of an image pickup apparatus;
Fig. 28 is a view showing the mode of division of the exit pupil;
Fig. 29 is a view showing the mode of division of the exit pupil when a large defocus is detected;
Fig. 30 is a circuit diagram of an area sensor unit in the image sensor element 100;
Fig. 31 is a cross-sectional view of the light-receiving unit;
Figs. 32 and 33 are circuit diagrams of an area sensor unit the image sensor element 100; and
Fig. 34 is a view showing an image pickup apparatus employing the image sensor element.

At first there will be explained a first embodiment of the present invention.

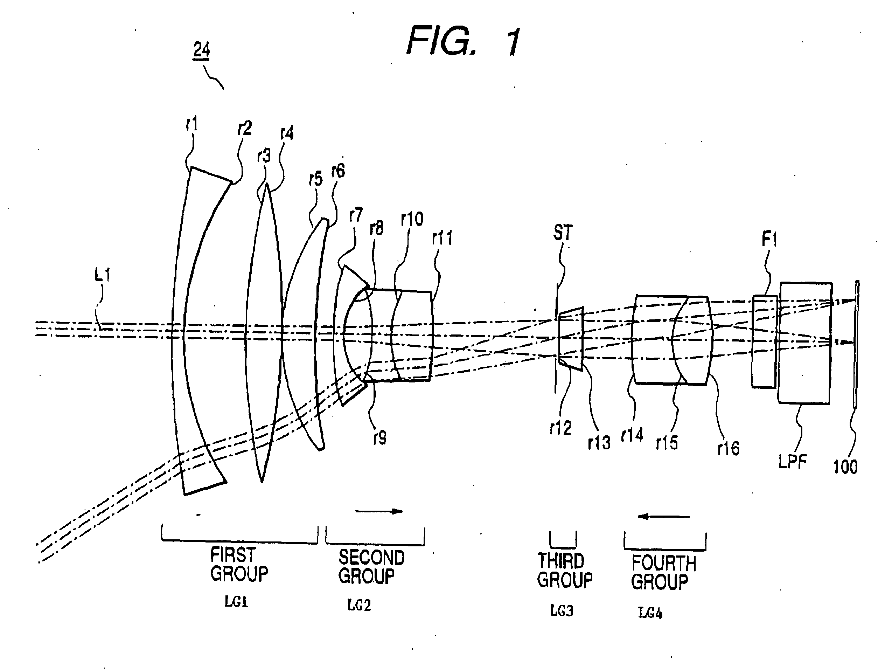

Fig. 1 is a view showing the configuration of an image pickup optical system of the present invention, which is a zoom optical system for an image pickup apparatus employing a solid-state image sensor. In Fig. 1, the object side and the image side are shown respectively in the left-hand side and right-hand side of the drawing. The image pickup optical system 24 is composed of a positive first group LG1 consisting of a negative lens and two positive lenses, a negative second group LG2 consisting of a negative lens and adhered negative and positive lenses, a positive third group LG3 consisting of a diaphragm stop ST and a positive lens, and a fourth group M4 consisting of adhered negative and positive lenses. There are also provided an infrared cut-off filter F1 and an optical low-pass filter LPF, and the optical axis L1 of the image pickup optical system 24 is also shown.

As the focal length is shifted from the wide angle side to the telephoto side by zooming, the negative second group and the positive fourth group simultaneously move respectively toward the image side and the object side as indicated by arrows in the drawing.

The image pickup optical system 24 is provided with an lens driving mechanism (not shown) for moving the negative second group in the axial direction by means of a motor and a gear train, thereby effecting focusing in such a manner that the object image is focused on an image sensor element 100.

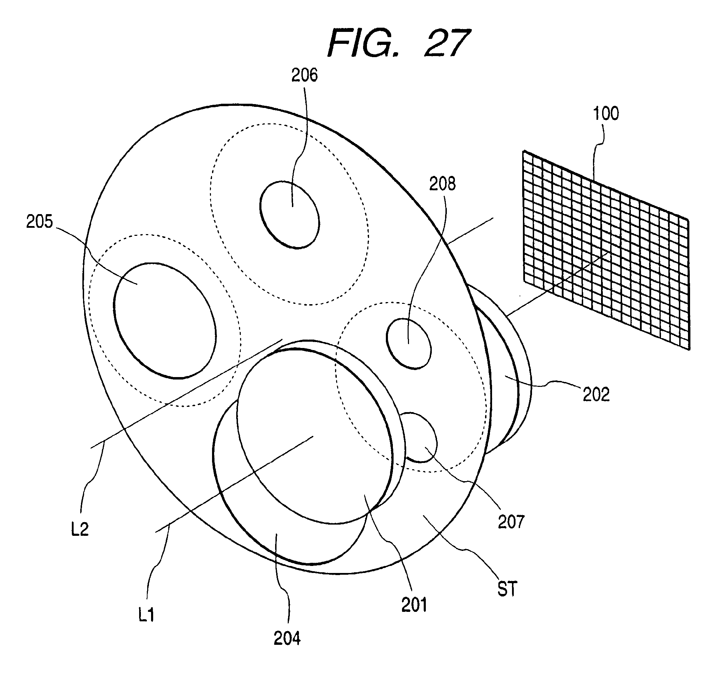

Fig. 27 is a perspective view of the image pickup apparatus, in which shown are a front lens group 201 collectively indicating the first and second groups positioned in front of the diaphragm stop ST within the image pickup optical system 24, and a rear lens group 202 collectively indicating the third and fourth lens groups and the optical low-pass filter LPF positioned closer to the image side than the diaphragm stop ST within the image pickup optical system 24. An image of the object is formed on the image sensor element 100 by a light beam passing through the aperture of the diaphragm stop ST. The diaphragm stop ST rotates about an axis L2 and selectively assumes four positions by the driving force of an motor (not shown). The diaphragm stop ST is provided with five apertures 204 to 208, of which those 204 to 206 are used for picking up the image while those 207 and 208 are used for detecting a large defocus.

In the following there will be explained the image sensor element 100 formed on a same semiconductor substrate and employed in the present embodiment.

The image sensor element 100 is a CMOS process compatible sensor (hereinafter represented as CMOS sensor) known as one of the amplification-type image sensors. The sensor of this type is disclosed for example in the IEEE Transactions on Electron Device, vol. 41, pp. 452 to 453 (1994).

One of the features of such CMOS sensor is to significantly decrease the number of masks and of process steps in comparison with the CCD sensor, because the MOS transistors in the light-receiving unit and those in the peripheral circuits can be prepared in a same process.

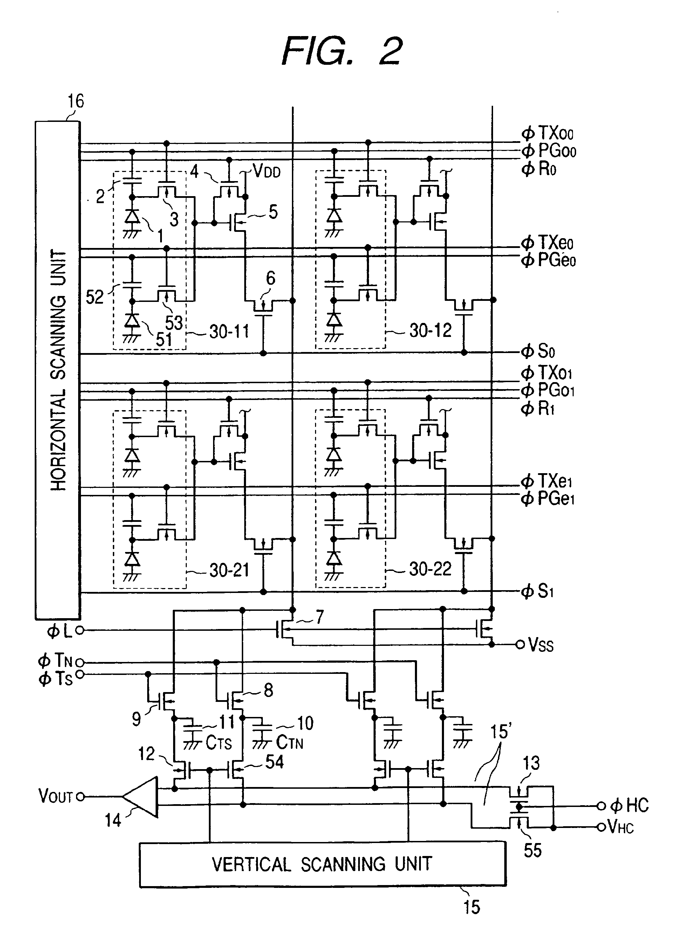

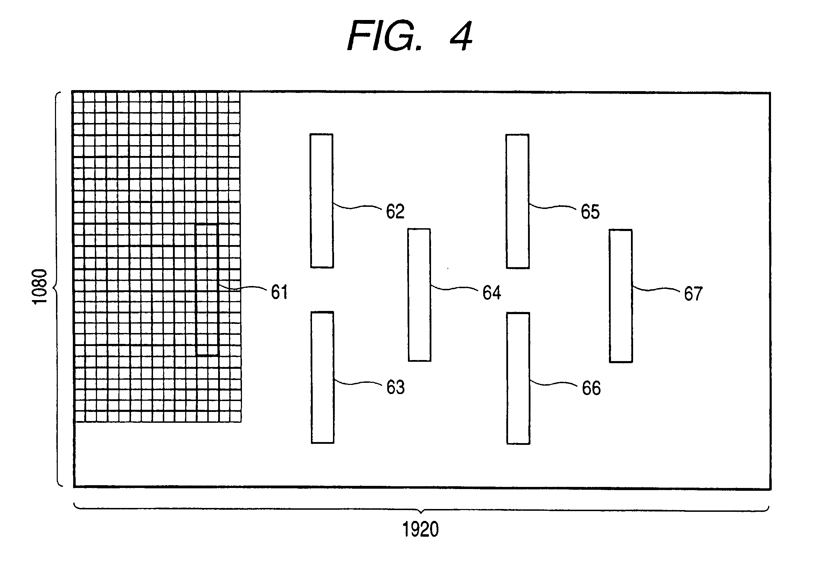

Fig. 2 is a circuit diagram of an area sensor unit in the image sensor element 100. Fig. 2 merely shows a two-dimensional sensor unit of 2 columns by 2 rows, but in practice the number of pixels is increased for example to 1920 columns by 1080 rows as shown in Fig. 4 for obtaining a practical resolving power. In Fig. 4 there are shown focus detection areas 61 to 67 to be explained later. The focus detection areas are made vertically oblong, in order to facilitate the detection of luminance distribution within a vertically oblong object such as a person.

Referring to Fig. 2, there are shown first and second photoelectric conversion units 1, 51 consisting of a MOS transistor gate and a depletion layer thereunder, photogates 2, 52, transfer switching MOS transistors 3, 53, a resetting MOS transistor 4, a source-follower amplifying MOS transistor 5, a vertical selection switching MOS transistor 6, a source-follower load MOS transistor 7, a dark output transferring MOS transistor 8, a light output transferring MOS transistor 9, a dark output accumulating capacitance C_{TN}, a light output accumulating capacitance C_{TS}, vertical transferring MOS transistors 12, 54, vertical output line resetting MOS transistors 13, 55, a differential output amplifier 14, a common output line 15', a vertical scanning unit 15, and a horizontal scanning unit 16.

The area sensor unit of the present embodiment is featured by fact that two photoelectric conversion units are formed for a pixel, that the floating diffusion area (FD area) and the source-follower amplifier which are conventionally provided for each photoelectric conversion unit are provided for every two photoelectric conversion units, and that the two photoelectric conversion areas are connected to the FD area through a MOS transistor switch.

Consequently the charges of the two photoelectric conversion units can be simultaneously or separately transferred to the floating diffusion area and can be added or not added in a simple manner by the operation timing of the transferring MOS transistor connected to the FD area. Utilizing such configuration, there is achieved a first output mode for outputting the photoelectrically converted output based on the light beam from the entire exit pupil of the image pickup optical system and a second output mode for outputting the photoelectrically converted output based on the light beam from a part of the exit pupil of the image pickup lens. The first mode executing the signal addition in the pixel level can provide a signal with a lower noise level, in comparison with the method of executing signal addition after the signal readout. Thus the added signal or non-added signal can be read through the common output line and the differential output amplifier, by controlling the transistors through the vertical and horizontal scanning units serving as the readout means.

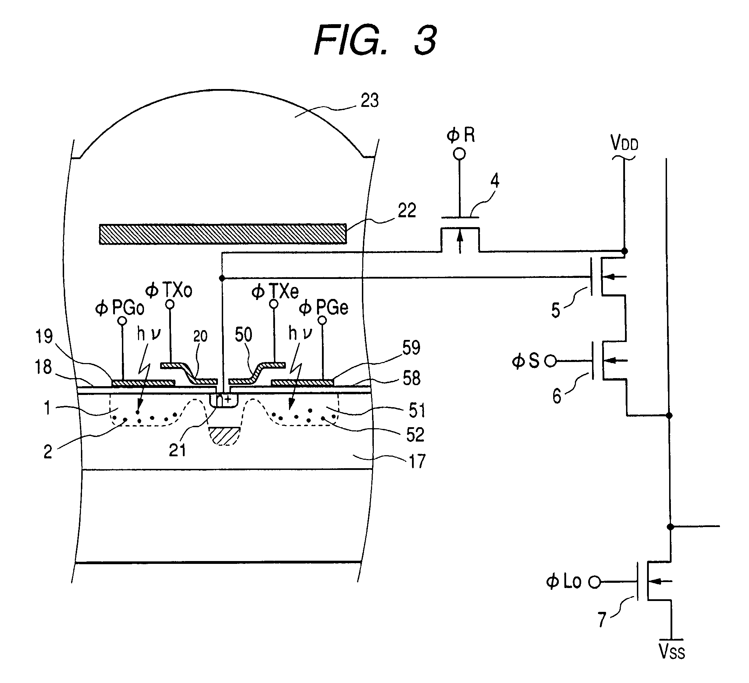

Fig. 3 is a cross-sectional view of a light-receiving unit (for example 30-11). The light-receiving units 30-21, 30-12 and 30-22 have a same structure.

In Fig. 3 there are shown a p-well 17, gate oxide films 18, 58, first polysilicon layers 19, 59, second polysilicon layers 20, 50, and an n⁺-floating diffusion area 21.

The FD area 21 is connected to the first photoelectric conversion unit 1 and the second photoelectric conversion unit 51 through the transfer MOS transistors 3, 53. The first photoelectric conversion unit 1 and the second photoelectric conversion unit 51 are mutually separate in Fig. 3, but the boundary therebetween is extremely small so that the first photoelectric conversion unit 1 and the second photoelectric conversion unit 51 can be regarded as mutually adjacent in practice. In the following, the mutually adjacent first and second photoelectric conversion units will be collectively called the light-receiving unit.

There are also shown a color filter 22 for transmitting the light of a specified wavelength region, and a microlens 23 for efficiently guiding the light from the image pickup optical system 24 to the first and second photoelectric conversion units.

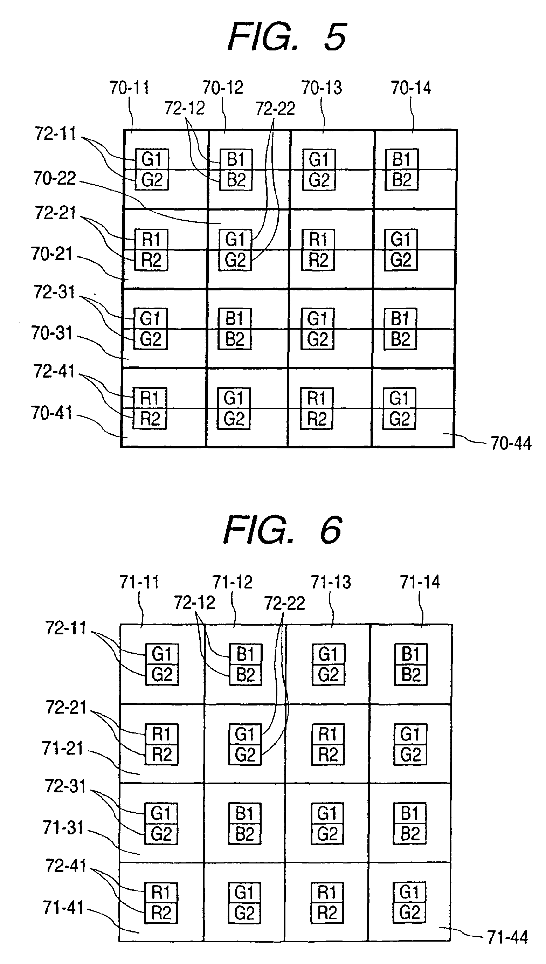

Fig. 5 is a plan view showing the arrangement of the pixels and the color filters, illustrating an area of 4 columns by 4 rows only. Each pixel including the light-receiving unit and the MOS transistors is substantially formed as a square, and such pixels are arranged in mutually adjacent manner in a grid pattern. The light-receiving units 30-11, 30-21, 30-12, 30-22 shows in Fig. 2 are positioned in the pixels 70-11, 70-21, 70-12, 70-22 and denoted with reference numerals 72-11, 72-12, 72-21, 72-22.

This area sensor has a color filter of R (red), G (green) and B (blue) color in each pixel and has so-called Bayer arrangement in which four pixels constitute a set. In the Bayer arrangement, the comprehensive imaging performance is improved by increasing the number of G pixels, more sensitive to the observer in observing an image, in comparison with the R or B pixels. In the image sensor element of this configuration, the luminance signal is generally generated from the G signal while the color signals are generated from the R, G and B signals.

As explained in the foregoing, each pixel is provided with two photoelectric conversion units. In Fig. 5, R, G and B respectively indicates the photoelectric conversion unit provided with a red, green or blue color filter, and the numeral "1" or "2" following R, G or B indicates the first or second photoelectric conversion unit. For example, R1 indicates the first photoelectric conversion unit provided with a red color filter, and G2 indicates the second photoelectric conversion unit provided with a green color filter.

In each pixel, the light-receiving unit occupies an area of about several ten per cent, so that, in order to effectively utilize the light beam emerging from the image pickup optical system 24, it is necessary to provide each light-receiving unit with a condensing lens for deflecting the light, directed toward an area outside the light-receiving unit, into such light-receiving unit.

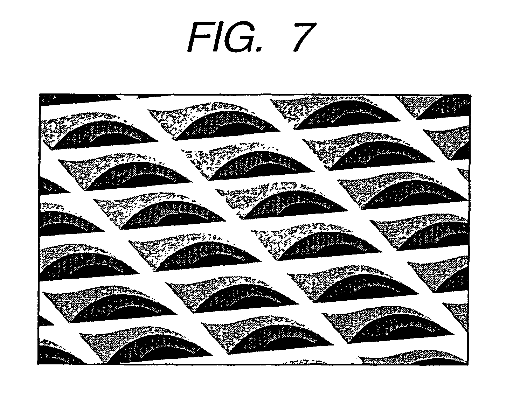

Fig. 6 is a plan view showing the positional relationship between microlenses provided for this purpose in front of the image sensor element and the light-receiving units. Microlenses 71-11 to 71-44 are axially symmetrical spherical or aspherical lenses having optical axes substantially coinciding with the centers of the light-receiving units. The microlenses have respectively rectangular effective areas and densely arranged in a grid pattern and being convex to the light entrance side. Fig. 7 is a perspective view showing the surface state of such microlenses.

In the following there will be explained the function of the microlenses.

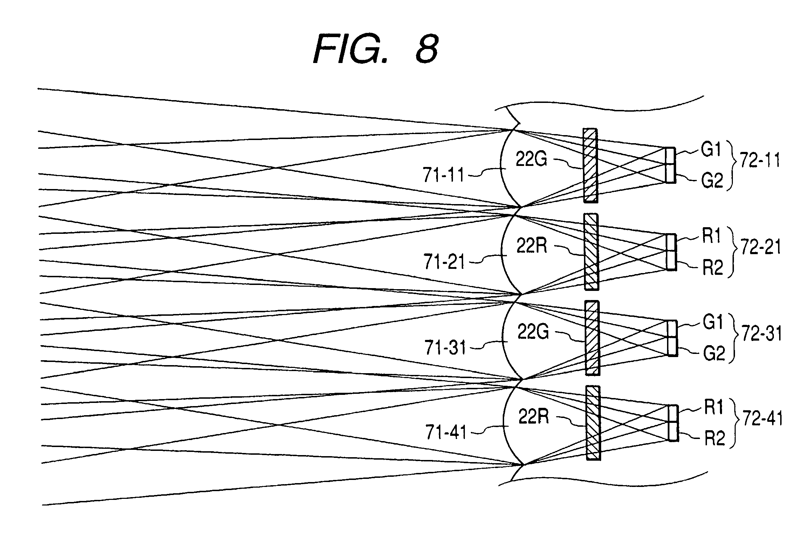

Fig. 8 is a cross-sectional view of the area sensor. The image pickup optical system 24 is positioned to the left side of the drawing, and the light beam emerging from the image pickup optical system 24 is transmitted by the IR cut-off filter F1 and the optical low-pass filter LPF and enters the microlenses 71-11, 71-21, 71-31, 71-41. Behind the microlenses there are provided color filters, whereby the light beams of the desired wavelength regions are selected and reach the light-receiving units 72-11 to 72-41. As already explained in the foregoing with reference to Fig. 5, the color filters are arranged in the Bayer arrangement and are provided in R, G and B colors. Because of the Bayer arrangement, only two of such color filters appear on the cross section, and 22G indicates a color filter transmitting the green light while 22R indicates a color filter transmitting the red light.

Each microlens has such a power as to project each light-receiving unit of the image sensor element onto the exit pupil of the image pickup optical system 24. The projecting magnification is so selected that the projected image of each light-receiving unit becomes larger than the exit pupil of the image pickup optical system when the diaphragm stop is fully opened, and the relationship between the amount of light falling onto the light-receiving unit and the aperture of the diaphragm stop ST of the image pickup optical system is made substantially linear. In this manner the diaphragm stop value and the shutter speed can be calculated when the luminance of the object and the sensitivity of the image sensor element are given, by a method similar to that employed in the conventional camera for the photographic film. More specifically the amount of incident light becomes proportional to the area of the aperture of the diaphragm stop whereby the calculation according to the APEX method stands. Thus the exposure amount can be calculated with an ordinary exposure meter as in the conventional camera and the image pickup operation becomes extremely easy.

Also, as the light beam for focus detection varies according to the aperture of the diaphragm stop ST, the image pickup light beam always coincides with the focus detecting light beam and there is obtained an advantage that the result of focus detection always coincides, within the error of the lens aberrations, with the actual best focus position of the image pickup optical system. When the object image formed by the image pickup optical system 24 is positioned on the microlenses, the image obtained from the image sensor element 100 becomes sharpest.

The image pickup optical system 24 is desirably formed as a telecentric system having a zero incident angle of the principal ray to the image sensor element, in consideration of the pupil projecting luminance by the microlenses, but it may not become a complete telecentric system because of the requirements for compactization and for a high zoom ratio. In such case, the microlenses may be slightly off-centered from the light-receiving units, with the amount of such off-centering being defined as a function of the distance from the optical axis of the image pickup optical system to the light-receiving unit. In general, also the light-receiving unit in the peripheral area of the image can be properly projected onto the exit pupil of the image pickup optical system 24 by monotonously increasing such amount of the off-centering with the increase in the above-mentioned distance.

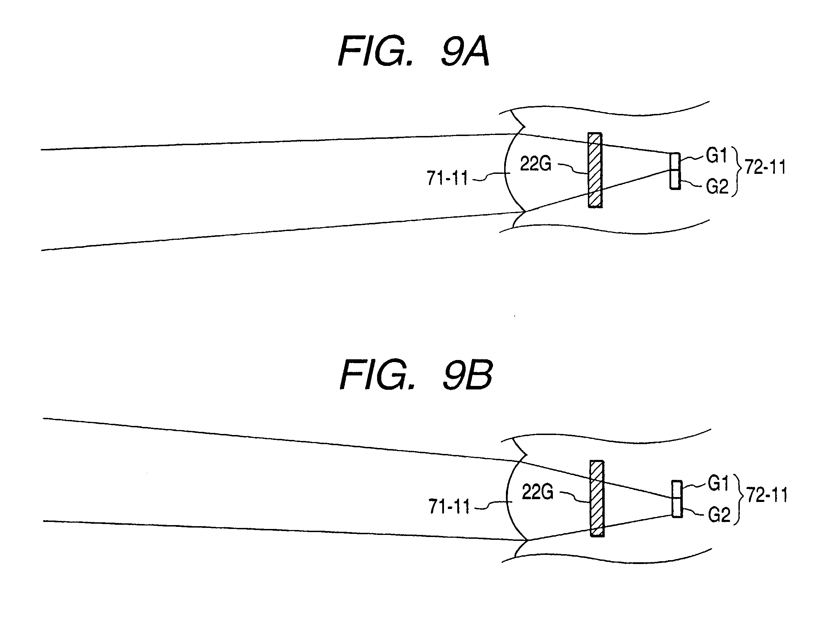

For easy understanding Figs. 9A and 9B are views separately showing the light beam entering the first photoelectric conversion unit and that entering the second photoelectric conversion unit for the light-receiving unit 72-11 shown in Fig. 8. It will be understood that, in Fig. 9A showing the light beam entering the first photoelectric conversion unit, a light beam coming from the lower part of the drawing enters the first photoelectric conversion unit G1 while, in Fig. 9B showing the light beam entering the second photoelectric conversion unit, a light beam coming from the upper part of the drawing enters the second photoelectric conversion unit G2.

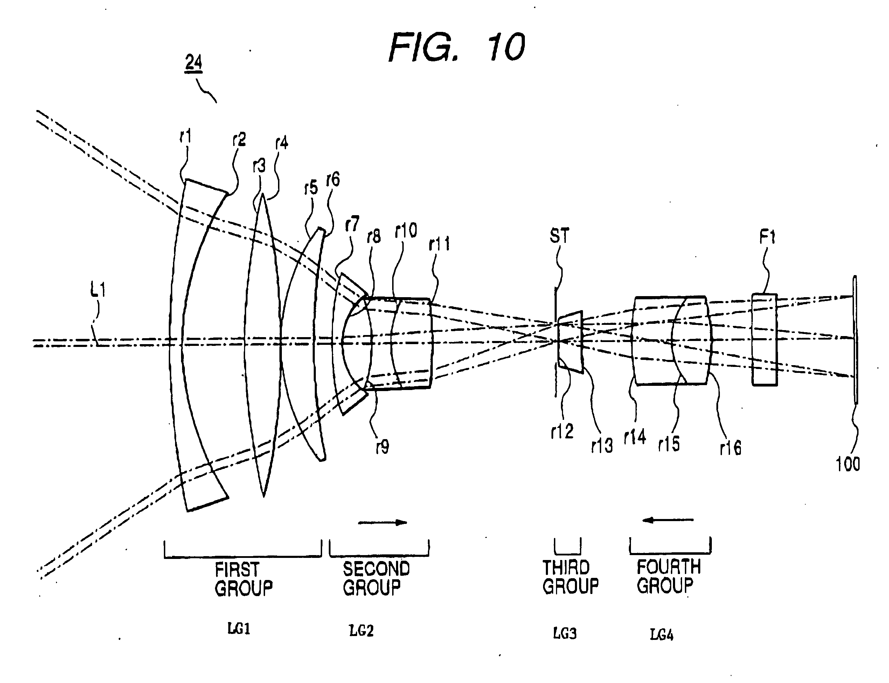

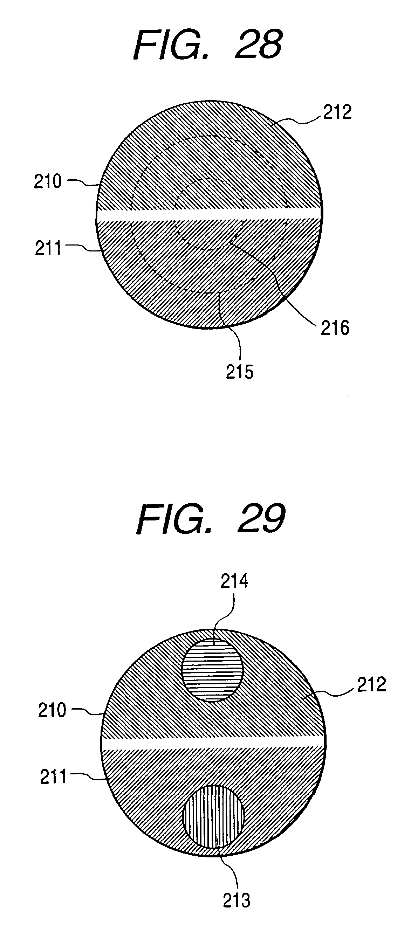

Therefore, in the entire image sensor element, the light beams entering the second photoelectric conversion units become as shown in Fig. 10. The light beam entering any part of the area sensor passes the upper half of the diaphragm stop ST. On the other hand, in the entire image sensor element, the light beams entering the first photoelectric conversion units can be represented by vertically inverting Fig. 10 with respect to the optical axis L1 of the image pickup lens. Thus the exit pupil is divided as shown in Fig. 29, in which 210 indicates the exit pupil of the image pickup optical system 24 when the diaphragm stop ST is fully open and is a false image of the aperture 204 of the diaphragm stop ST seen through the rear lens group 202. Also there are shown a first area 211 which is passed by the light beams entering the first photoelectric conversion units of the image sensor element 100, and a second area 212 which is passed by the light beams entering the second photoelectric conversion units of the image sensor element 100.

Also 215, 216 indicate exit pupils when the aperture of the diaphragm stop ST is made smaller and are false images of the apertures 205, 206 of the diaphragm stop ST seen through the rear lens group 202. When the aperture of the diaphragm stop ST is closed smaller, the first and second areas 211, 212 become smaller corresponding to the state of such closing, and the image signal obtained from the first photoelectric conversion units and that obtained from the second photoelectric conversion units are respectively formed by half light beams passing through the substantial halves of the exit pupil of the image pickup optical system 24.

In the above-described optical system, when the object image is formed in front of the image sensor element 100, the half light beam passing the upper part of the pupil is shifted downwards on the image sensor element 100 while the half light beam passing the lower part of the exit pupil is shifted upwards. Thus, a pair of image signals formed by the light beams passing through the respective halves of the pupil of the image pickup optical system 24 are shifted in phase in the vertical direction in Figs. 5, 6 and 8 according to the focus state of the object image. In the present embodiment, there has been explained a configuration having a microlens for two photoelectric conversion units as the means for dividing the image of the object into two images, but there may also be adopted any other configuration capable of dividing the object image into two images.

In case of fetching image information by an image sensor element, there is generated a noise image, called "aliasing noise", of a low frequency different from the high frequency component of the spatial luminance distribution on the object, resulting from the discrete image sampling. Such noise results in so-called "color moiree" in the digital color camera. Also in case of executing focus detection of the phase difference detection method utilizing the output of the image sensor element, such aliasing noise deteriorates the detecting precision of the defocus amount, since the phase information of the object image is not correctly reflected on the image output.

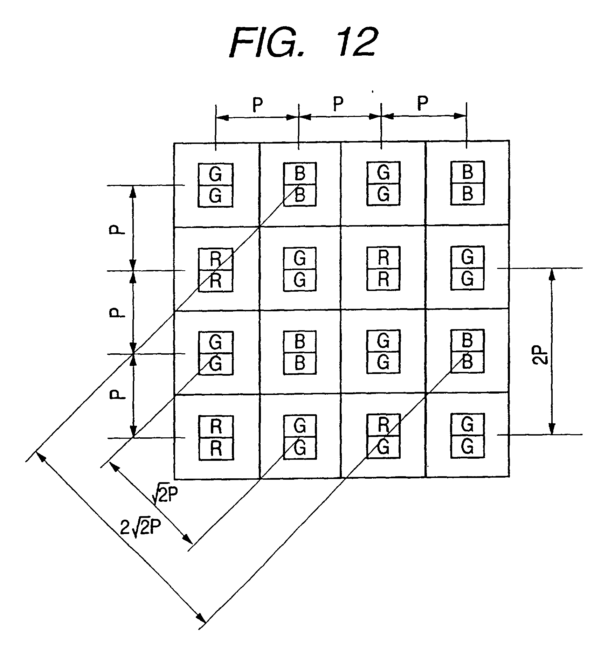

For a pixel pitch P of the image sensor element 100, the pitch of the pixels having green color filters becomes 2P in the vertical and horizontal directions and √2P in the diagonal direction as shown in Fig. 12, and the pitch of the pixels having blue or red color filters becomes 2P in the vertical and horizontal directions and 2√2P in the diagonal direction. Also the pitch of the pixels used for focus detection is 2P between the G pixels, between the B pixels and between the R pixels in the vertical direction.

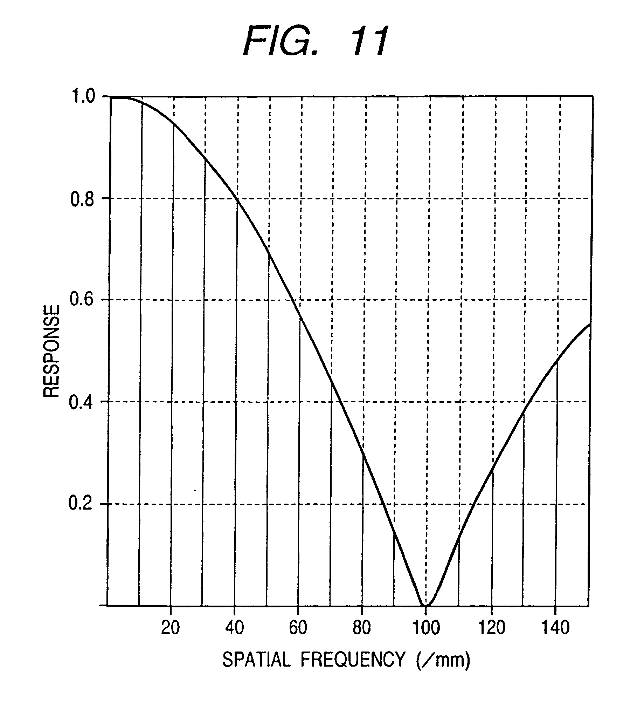

For a pitch P of 0.0025 mm, the Nyquist frequency in the vertical and horizontal directions is represented by vn = 1/(2 × 2P) = 100, so that the response characteristics of the image sensor element 100 becomes as shown in Fig. 11 for R, G and B. In Fig. 11, the abscissa indicates the spatial frequency while the ordinate indicates the response, and a lifted portion at the high frequency side after the response once becomes zero represents the aliasing noise.

In order to prevent such drawback, it is necessary to prevent the high frequency component of the object from reaching the image sensor element in the optical image level. The aliasing noise can be substantially prevented by positioning an optical low-pass filter LPF consisting of quartz between the image pickup optical system 24 and the image sensor element 100 and selecting the characteristics of such optical low-pass filter in such a manner that the MTF (modulation transfer function) approaches zero at the Nyquist frequency vn.

However, the MTF does not necessarily become zero at the Nyquist frequency in the optical low-pass filter LPF utilizing the double refraction characteristics of quartz, so that the high frequency component not desirable for the focus detection may also be fetched. However, since the samplings of the R and B images are shifted by a half pitch and there are also provided systems with a half pitch shift for the G image as well as the relation between the R and B images, there can be obtain a sufficient accuracy of focus detection by determining the outputs of focus detection for the R and B images and for the two G image systems and averaging these outputs.

Also in the in-focus state, the phase error is applied equally to a pair of signals, so that such phenomenon does not give rise to an error in the focus detection. This means that the final focusing can be assured even in case there is obtained only one output of the focus detection so that the averaging cannot be executed.

Because of the characteristics of such optical low-pass filter, a ray entering the optical low-pass filter LPF formed as a parallel-faced flat plate emerges as two parallel rays. If the incident light is parallel to the emerging light, the image of each light-receiving unit projected by the microlens onto the exit pupil of the image pickup optical system 24 merely generates a blur of about 2P, which is practically acceptable. There is also known an optical low-pass filter in which an incident ray emerges in a diffused state, but, in such type, since the incident lights are not parallel, the images of the light-receiving units projected by the microlenses onto the exit pupil of the image pickup optical system 24 are significantly deformed, so that the focus detection system cannot perform properly.

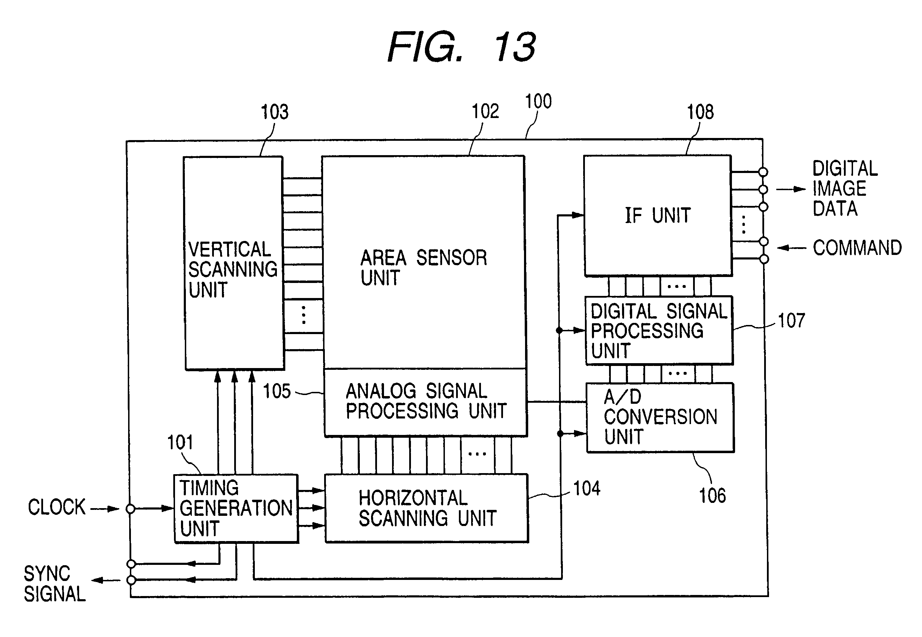

Fig. 13 is a block diagram showing the internal configuration of the image sensor element 100 including peripheral circuits thereof. In the image sensor element 100, there are provided a timing generation unit 101, an area sensor unit 102, a vertical scanning unit 103 and a horizontal scanning unit 104 for selecting the outputs of the pixels, an analog signal processing unit 105, an A/D conversion unit 106 for executing analog/digital conversion, a digital signal processing unit 107 for converting a digitized signal into an output signal, and an interface unit 108 for outputting the digital image signal and receiving external command data.

The area sensor unit 102 is composed of the CMOS sensor described in the foregoing.

The timing generation unit 101 generates a timing signal for reading the image signal obtained by photoelectric conversion in each pixel, based on a master clock which is an externally supplied reference frequency, and the vertical and horizontal scanning units 103, 104 execute predetermined scanning control according to the timing signal to read out the charges obtained by photoelectric conversion in the pixels. The timing generation unit 101 also outputs a vertical sync signal and a horizontal sync signal to the exterior, as the sync signals for an external system requiring the timing signal.

The analog signal processing unit 105 executes noise reduction, amplification, gamma treatment and clamping on the image signal read from the area sensor unit 102, and outputs the processed signal to the A/D conversion unit 106. The A/D conversion unit 106 converts the image signal into a digital signal, and the digital signal processing unit 107 outputs the image signal, digitized in the A/D conversion unit 106, to the interface unit 108 through a switch 107b.

The interface unit 108 outputs the digital image signal, outputted from the digital signal processing unit 107, to the exterior of the image sensor element 100.

Also in response to an externally supplied command, the image sensor element 100 can control the operation mode, output signal format, signal output timing etc., and the interface unit 108, in response to the command externally supplied thereto, controls various components so as to execute an operation corresponding to the command.

The image sensor element 100 can execute a first output mode for providing a photoelectric conversion output based on the light beam from the entire exit pupil of the image pickup lens, and a second output mode for providing a photoelectric conversion output based on the light beam from a part of the exit pupil of the image pickup lens.

In the following there will be explained an image output for focus detection as the adjustment for the image pickup operation. As already explained with reference to Figs. 8, 9A, 9B and 10, the images for focus detection are obtained by executing photoelectric conversion substantially simultaneously on a pair of object images formed in the second output mode and independently outputting the image signal from the first photoelectric conversion units and that from the second photoelectric conversion units.

If the object image projected on the focus detection area is defocused, these image signals are shifted in phase in the direction of division of the pupil. Therefore, by forming the focus detection area in a rectangle oblong in the direction of division of the pupil of the image pickup optical system, the amount of phase shift can be detected with the image signals which are continuous over a long range, so that the accuracy of detection of the shift amount can be improved.

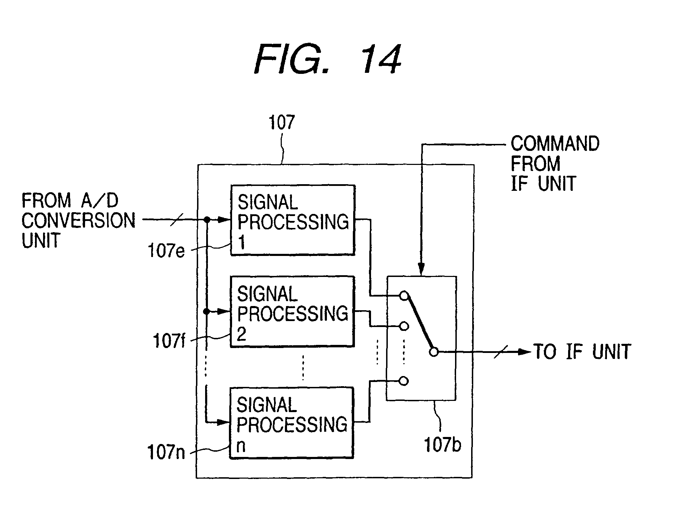

In order to easily obtain the image for focus detection, there is prepared an output position designating command as one of the commands of the aforementioned digital signal processing unit 107. Such output position designating command is represented by 107e, .., 107n in Fig. 14 and designates any of the focus detection area 61 to 67 in Fig. 4 or a combination thereof, in the image pickup area of the area sensor unit 102. It is also possible, instead of selecting the predetermined focus detection areas, to arbitrarily designating certain of several hundred focus detection areas by a pointing device such as a tracking ball.

A line including such designated specified area is so constructed, for the purpose of focus detection, as to output an image optimized in the charge accumulation level. Though the image sensor element of CCD type has a same charge accumulation time for all the pixels, the image sensor element 100, being composed of a CMOS sensor, can easily adopt a configuration for signal readout in the unit of a pixel, a line or a block, and the start and end of the accumulation time can be made different for each unit. In the present embodiment, the charge accumulation time is made different for each vertical line, in order that the image within the focus detection area can effectively utilize the A/D conversion range.

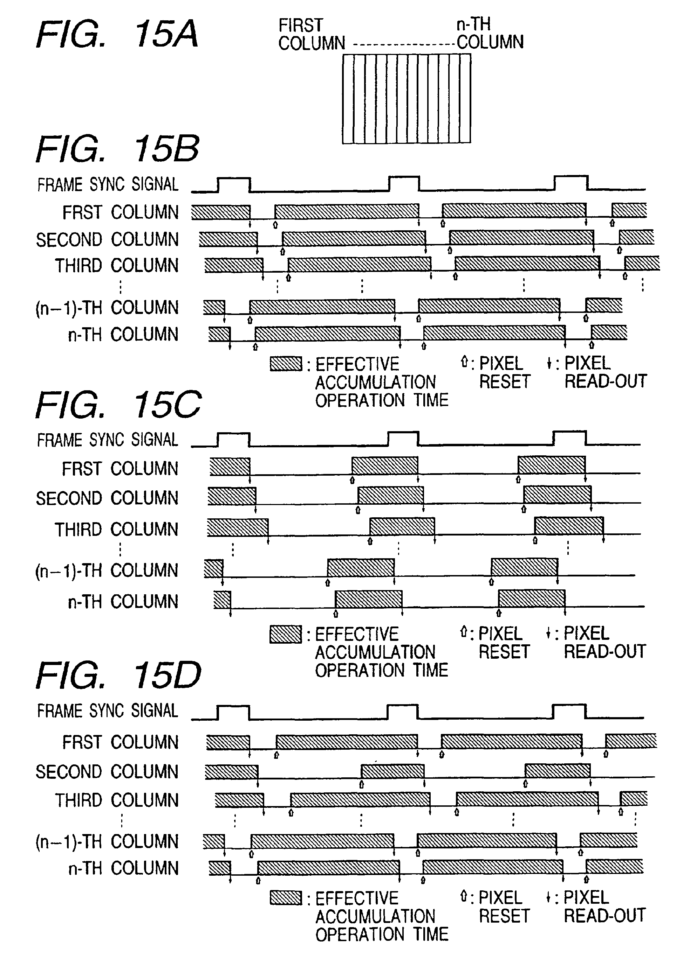

Now the electronic shutter function will be explained with reference to Figs. 15A to 15D. In case of reading the pixels sequentially in the vertical line as shown in Fig. 15A, at first the ineffective charges accumulated in the pixels as shown in Fig. 15B are reset and the effective accumulating operation is initiated. After the lapse of a predetermined time, the pixels are read to give the image signal to the succeeding signal processing unit. The effective accumulating operation is different in timing in each vertical line, but the accumulating time remains substantially same.

In case of reducing the charge accumulating time for the entire image, the timing of resetting the ineffective charge is delayed as shown in Fig. 15C to shorten the effective accumulating time, thereby achieving an electronic shutter function. This function can be attained by switching the mode of the timing generation unit 101 by an electronic shutter command received by the interface unit 108.

In case of setting the effective accumulating time in the unit of a vertical line, there is executed an operation as shown in Fig. 15D, showing an example in which the effective accumulating time for the second line is made different from that in other lines, in order to obtain an appropriate signal level for the second line in case the focus detection area is selected therein.

The focus detection images thus obtained are a pair of images formed by the half light beams in the second output mode as explained in the foregoing, and are based on the accumulation time different from that for other lines, but the information of a condition same as that in other lines can be easily obtained in signal processing by adding these focus detection images and multiplying a gain so as to cancel the difference in the accumulating time. Therefore, in case of displaying the picked-up image on the monitor, the above-described process allows to obtain the information of the entire image while executing the focus detection at the same time.

Now the reference is made again to Figs. 2 and 3 for explaining the details of the charge accumulating operation of the image sensor element.

At first, positive voltages are applied as control pulses ΦPG₀₀, ΦPGₑ₀ for expanding the depletion layers under the photogates 2, 52. In order to prevent the blooming phenomenon, the FD area 21 is fixed at the power supply voltage V₀₀ by setting the control pulse ΦR₀ at the high level state during the accumulating operation. When the carriers are generated under the photogrates 2, 52 by the irradiation with photons hv, the electrons are accumulated in the depletion layers under the photogates 2, 52, while the positive holes are discharged through the P-well 17.

Energy barriers are formed between the photoelectric conversion unit 1 and the FD area 21 by the transfer MOS transistor 3 and between the photoelectric conversion unit 51 and the FD area 21 by the transfer MOS transistor 53. Therefore the electrons remain under the photogates 2, 52 during the photocharge accumulation. The charge accumulation is achieved in all the photoelectric conversion units by a similar charge accumulating operation through the scanning operation of the horizontal scanning unit.

In the charge readout state, the control pulses ΦPG₀₀, ΦPGₑ₀, ΦTX₀₀, ΦTXₒ₀ are so set as to eliminate the barrier under the transfer MOS transistor 3 or 53 thereby completely transferring the electrons under the photogate 2 or 52 to the FD area 21.

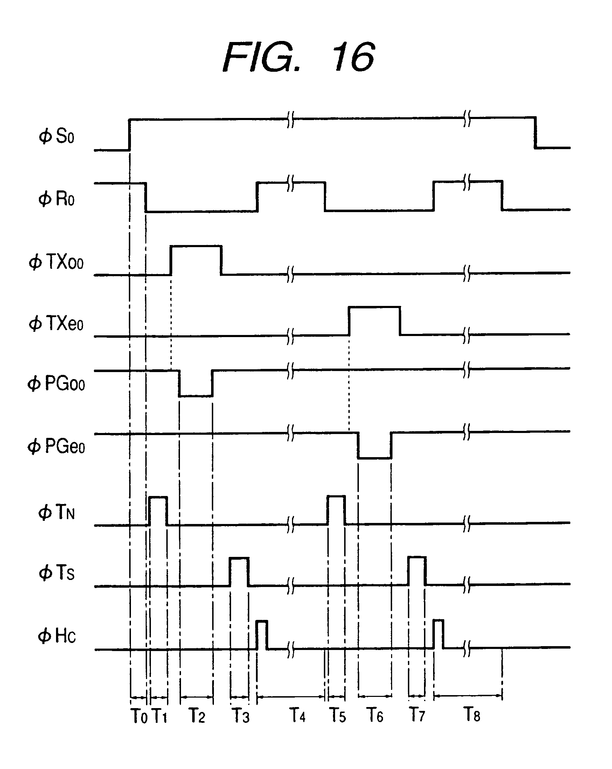

The charge readout operation of the image sensor element will be explained with reference to a timing chart shown in Fig. 16, which shows the second output mode for independently outputting the charges of the two photoelectric conversion units, for reading the focus detection images.

At first, in response to the output of a timing signal from the horizontal scanning unit 16, a control pulse φL is shifted to the high level state for resetting the horizontal output line. Also control pulses ΦR₀, ΦPG₀₀, ΦPGₒ₀ are shifted to the high level state for turning on the resetting MOS transistor 4 and maintaining the first polysilicon layer 19 of the photogate 2 at the high level state. At a time T₀, a control pulse ΦS₀ is shifted to the high level state to turn on the selection switch MOS transistor 6 thereby selecting the light-receiving unit 30-11. Then the control pulse ΦR₀ is shifted to the low level state to terminate the resetting of the FD area 21 thereby maintaining the FD area 21 in a floating state, and to realize a through state between the gate and the source of the source-follower amplifying MOS transistor 5. Then, at a time T₁, a control pulse T_{N} is shifted to the high level state whereby the dark voltage of the FD area 21 is outputted by the source-follower operation to the accumulating capacitance C_{TN}1.

Then, for executing the photoelectric conversion output of the first photoelectric conversion units, the control pulse ΦTX₀₀ therefor is shifted to the high level state to turn on the transfer switch MOS transistor 3, and the control pulse φPX₀₀ is shifted to the low level state at a time T₂. In this state there is preferred such a voltage relationship as to elevate the potential well spread under the photogate 2, thereby completely transferring the photo-generated carriers to the FD area 21.

As the charge from the photoelectric conversion unit 1 of the photodiode is transferred to the FD area 21 at the time T₂, the potential of the FD area 21 varies according to the light intensity. As the source-follower amplifier MOS transistor 5 is in the floating state at this point, a control pulse ΦTₛ is shifted to the high level state at a time T₃ to output the potential of the FD area 21 to the accumulating capacitance C_{TS}11. At this point, the dark output and the light output of the first photoelectric conversion unit are respectively accumulated in the accumulating capacitances C_{TN}10 and C_{TS}11. At a time T₄, a control pulse φHC is temporarily shifted to the high level state to turn on the vertical output line resetting MOS transistors 13, 55 thereby resetting the vertical output line, and the dark output and the light output of the pixels are outputted to the vertical output line by the scanning timing signal of the vertical scanning unit 15 during the vertical transfer period. A differential output V_{OUT} between the accumulating capacitances C_{TN}10 and C_{TS}11 is obtained by the differential amplifier 14, thereby providing a signal of satisfactory S/N ratio without the pixel random noise and the fixed pattern noise.

The photocharges of the light-receiving unit 30-12 are accumulated in the accumulating capacitances C_{TS} and C_{TN} thereof simultaneously with the accumulating operation of the light-receiving unit 30-11, but are read out to the vertical output line by a timing pulse form the vertical scanning unit 15 with a delay by one light-receiving unit and outputted from the differential amplifier 14. The accumulating time can be regarded substantially same for both units, since the time difference therebetween is only a timing pulse corresponding to one light-receiving unit.

Then, after the output of the light output to the accumulating capacitance C_{TS}11, the control pulse φR₀ is shifted to the high level state to turn on the resetting MOS transistor 4, thereby resetting the FD area 21 to the power supply voltage VDD.

After the vertical transfer of the charges of the first photoelectric conversion units, there is executed the readout of the second step photoelectric conversion units. The readout of the second photoelectric conversion units is executed by shifting the control pulse φR₀ to the low level state, thereby terminating the resetting of the FD area 21 and maintaining the FD area 21 in the floating state and realizing a through state between the gate and the source of the source-follower amplifier MOS transistor 5. Then, at a time T₅, the control pulse φT_{N} is shifted to the high level state to output the dark potential of the FD area 21 to the accumulating capacitance C_{TN}10 by the source-follower function.

Then, for executing the photoelectric conversion output of the second photoelectric conversion units, the control pulse φTXₑ₀ therefor is shifted to the high level state to turn on the transfer switch MOS transistor 53, and the control pulse φPGₑ₀ is shifted to the low level state at a time T₆.

As the charge from the photoelectric conversion unit 2 of the photodiode is transferred to the FD area 21 at the time T₆, the potential of the FD area 21 varies according to the light intensity. As the source-follower amplifier MOS transistor 5 is in the floating state at this point, a control pulse φTₛ is shifted to the high level state at a time T₇ to output the potential of the FD area 21 to the accumulating capacitance C_{TS}11. At this point, the dark output and the light output of the second photoelectric conversion unit are respectively accumulated in the accumulating capacitances C_{TN}10 and C_{TS}11. At a time T₈, a control pulse φHC is temporarily shifted to the high level state to turn on the vertical output line resetting MOS transistors 13, 55 thereby resetting the vertical output line, and the dark output and the light output of the pixels are outputted to the vertical output line by the scanning timing signal of the vertical scanning unit 15 during the vertical transfer period. A differential output V_{OUT} between the accumulating capacitances C_{TN}10 and C_{TS}11 is obtained by the differential amplifier 14.

The above-described operations allow to independently read out the first and second photoelectric conversion units.

The independent output of all the photoelectric conversion units can be obtained by thereafter executing the readout operation in a similar manner by activating the horizontal scanning unit. More specifically, in the next column, the signals of the first photoelectric conversion units of the light-receiving units 30-12, 30-22 are read by at first shifting a control pulse φS₁ to the high level state, then shifting a control pulses φT_{N}, φTX₀₁ to the high level state, and also shifting a control pulse φPG₀₁ to the low level state, a control pulse φTₛ to the high level state and a control pulse φHC temporarily to the high level state. Then the signals of the second photoelectric conversion units of the light-receiving units 30-21, 30-22 are read by applying control pulses φTXₑ₁, φPGₑ₁ and other control pulses similar to those explained above.

As the two photoelectric conversion units of a pixel are not respectively provided with the source-followers but are provided with only one source-follower, the number of the source-follower amplifier MOS transistors 5, selection switch MOS transistors 6 and resetting MOS transistors 4 can be reduced to a half in comparison with the conventional configuration. It is thus rendered possible to increase the aperture rate of the photoelectric conversion units within a pixel, and to realize miniaturization by pixel integration, thereby significantly facilitating the use for focus detection. Also as the FD area 21 is commonly used for the two photoelectric conversion units, it is not required to increase the gate capacitance of the source-follower amplifier MOS transistor 5, so that the loss in sensitivity can be prevented.

In the following there will be explained the first output mode for outputting a signal based on the light beam coming from the entire pupil of the objective lens, by adding the signals of the first and second photoelectric conversion units in the FD area 21. This operation mode corresponds to the ordinary image output in the image sensor element.

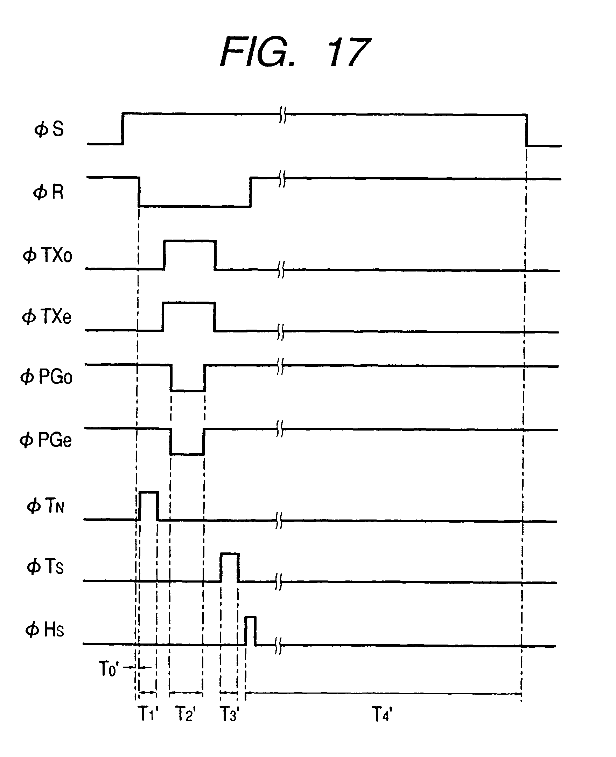

Fig. 17 is a timing chart in case of adding the signals of the first and second photoelectric conversion units. In the non-adding mode shown in Fig. 16, the control pulses φTX₀₀, φTXₑ₀, φPG₀₀, φPGₑ₀ are displaced in timing, but they are given at a same timing in case of the adding mode. More specifically, for executing simultaneous reading of the first and second photoelectric conversion units of the light-receiving unit 30-11, the control pulse φT_{N} is at first shifted to the high level state to read the noise component from the horizontal output line, and the control pulses φTX₀₀, φTXₑ₀ and φPG₀₀, φPGₑ₀ are simultaneously shifted to the high and low level states respectively, thereby executing transfer to the FD area 21. In this manner it is rendered possible to add the signals of the upper and lower two photoelectric conversion units at a time in the FD area 21. Since the addition is executed at the image level, the obtained signal is not affected by the amplifying noise provides a high S/N ratio which cannot be attained by the addition after the signal readout.

As explained in the foregoing, it is possible to obtain the focus detecting images for focus detection of the image pickup lens by the signal readout in the timing shown in Fig. 16, and the ordinary image based on the entire light beam by the signal readout in the timing shown in Fig. 17. More specifically, the control means constituted by the transfer switch MOS transistors 3, 53, the source-follower amplifier MOS transistor 5 and the vertical scanning unit 15 for controlling the timing of pulses to the transfer switch MOS transistors 3, 53 executes reading of the signals from the first photoelectric conversion unit for executing photoelectric conversion on the light beam from a first area of the exit pupil and the second photoelectric conversion unit for executing photoelectric conversion on the light beam from a second area of the exit pupil, either in an adding mode or in a non-adding mode. Stated differently, there can be executed a first output mode for photoelectric conversion output based on the light beam coming from the entire exit pupil of the image pickup lens, and a second output mode for photoelectric conversion output based on the light beam coming from a part of the exit pupil of the image pickup lens.

The first output mode can provide a high quality image excellent in S/N ratio and without unnatural image blur, comparable to the image obtained with an image sensor element which is designed to provide an image based on the light beam coming from the entire pupil of the image pickup optical system.

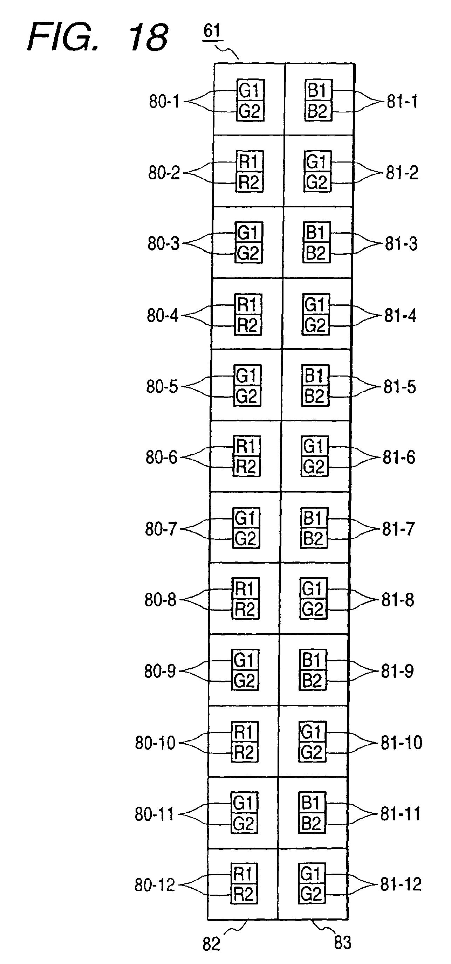

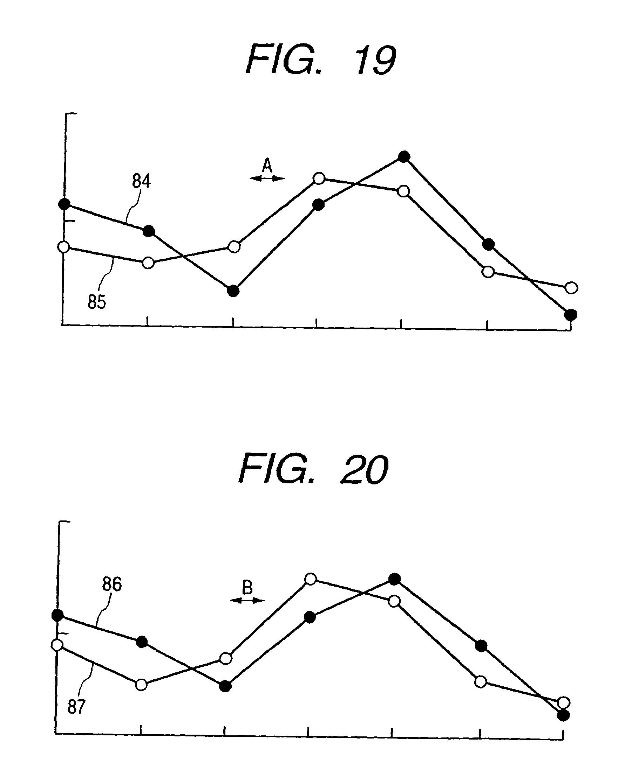

Now there will be explained the signal processing for focus detection. Fig. 18 is a magnified view of the focus detection area 61, and other focus detection areas 62 to 67 are also constructed similarly. Figs. 19 to 26 show the digital image signal outputted from the interface unit 108.

As shown in Fig. 18, the focus detection area 61 is provided with two sets of a pixel column composed of 12 light-receiving units. A pixel column 82 is composed of the light-receiving units 80-1 to 80-12, while a pixel column 83 is composed of the light-receiving units 81-1 to 81-12. In each pixel column, the color filters of two kinds are alternately arranged. For the purpose of focus detection, each pixel column is divided according to the kind of the color filter, and, from each divided groups, there are generated a pair of image signals consisting of the signals from the first photoelectric conversion units and those from the second photoelectric conversion units. Thus, 4 pairs of images signals are generated in total from the focus detection area 61. As explained in the foregoing, the accumulation time is maintained substantially same for a focus detection area.

Figs. 19 to 22 illustrate these four pairs of image signals.

Fig. 19 shows the image signals from the light-receiving units 80-1 to 80-11 provided with green color filters in the pixel column 82, including the signals 84 from the first photoelectric conversion units represented by G1, and those 85 from the second photoelectric conversion units represented by G2.

Fig. 20 shows the image signals from the light-receiving units 81-2 to 81-12 provided with green color filters in the pixel column 83, including the signals 86 from the first photoelectric conversion units represented by G1, and those 87 from the second photoelectric conversion units represented by G2.

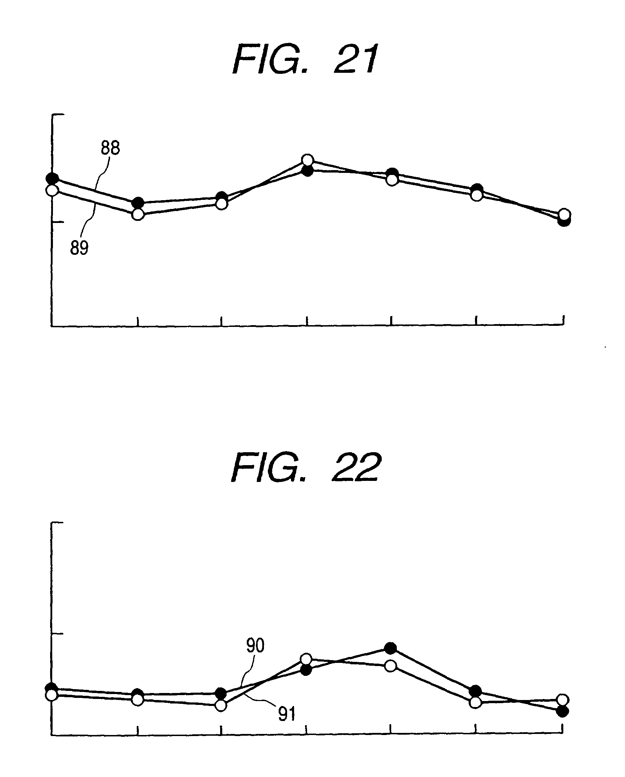

Fig. 21 shows the image signals from the light-receiving units 80-2 to 80-12 provided with red color filters in the pixel column 82, including the signals 88 from the first photoelectric conversion units represented by R1, and those 89 from the second photoelectric conversion units represented by R2.

Fig. 22 shows the image signals from the light-receiving units 81-1 to 81-11 provided with blue color filters in the pixel column 82, including the signals 90 from the first photoelectric conversion units represented by B1, and those 91 from the second photoelectric conversion units represented by B2.

These charts show an example in which the object image formed by the image pickup optical system 24 on the focus detection area 61 has orange and yellow colors in different gradation levels. Therefore, the green color shown in Figs. 19 and 20 has a high contrast, while the red color shown in Fig. 21 shows a low contrast but has a high intensity, and the blue color shown in Fig. 22 has a low contrast and low intensity. These charts correspond to a defocused state of the object image, so that the signals of the first photoelectric conversion units and those of the second photoelectric conversion units are shifted in phase as indicated by arrows A, B.

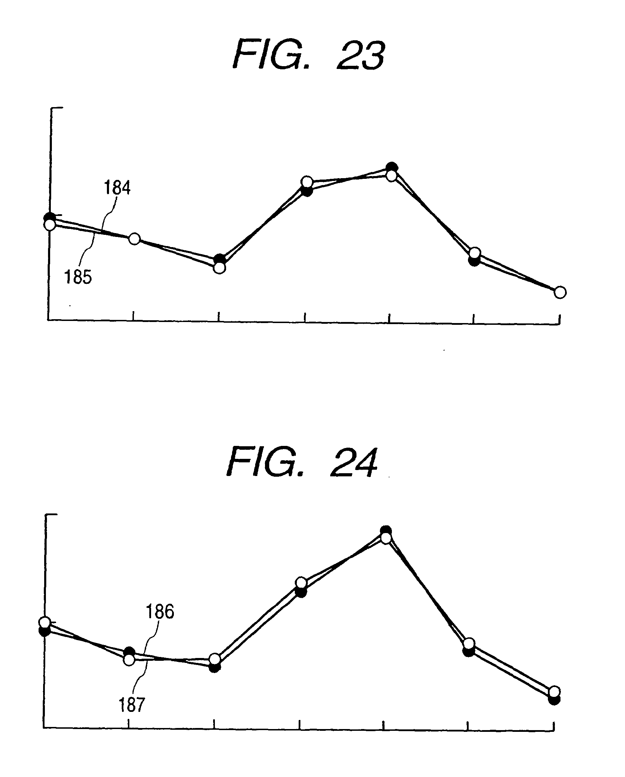

Also Figs. 23 to 26 indicate signals when the object image is in focus and show the changes in the signals shown in Figs. 19 to 22 caused by the movement of the second group of the image pickup optical system 24.

Fig. 23 shows the image signals from the light-receiving units 80-1 to 80-11 provided with green color filters in the pixel column 82, including the signals 184 from the first photoelectric conversion units represented by G1, and those 185 from the second photoelectric conversion units represented by G2.

Fig. 24 shows the image signals from the light-receiving units 81-2 to 81-12 provided with green color filters in the pixel column 83, including the signals 186 from the first photoelectric conversion units represented by G1, and those 187 from the second photoelectric conversion units represented by G2.

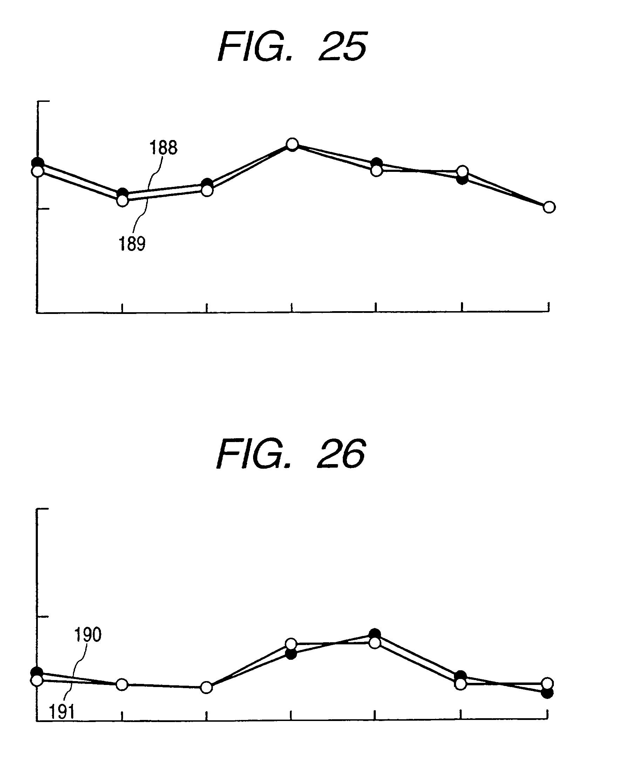

Fig. 25 shows the image signals from the light-receiving units 80-2 to 80-12 provided with red color filters in the pixel column 82, including the signals 188 from the first photoelectric conversion units represented by R1, and those 189 from the second photoelectric conversion units represented by R2.

Fig. 26 shows the image signals from the light-receiving units 81-1 to 81-11 provided with blue color filters in the pixel column 82, including the signals 190 from the first photoelectric conversion units represented by B1, and those 191 from the second photoelectric conversion units represented by B2.

When the lens is focused to the object, the signal of the first photoelectric conversion unit and that of the second photoelectric conversion unit mutually coincide in phase. Consequently the focus state can be detected by identifying the matching of the paired signals. Also the defocus amount can be determined by detecting the amount of defocus by a known method based on correlation calculation. Automatic focus adjustment is possible by converting the obtained defocus amount into the driving amount of the second group of the image pickup optical system 24. As the drive state of the lens can be known in advance, the lens driving to the in-focus position can be completed generally in one operation, so that extremely fast focusing operation can be realized.

As explained in the foregoing, there are employed color separated signals. Without such color separation, there has to be utilized a signal corresponding to the sum of the color separated signals, so that the contrast tends to become low and the focus detection becomes often impossible. On the other hand, with the color separated signals, a high contrast may not be obtained in all the R, G and B signals but is usually obtained in either one of such signals, so that the focus detection is possible in most cases.

Although the image sensor element 100 receives the object image after passing the optical low-pass filter LPF, but, because of the characteristics of the optical system, a high frequency component exceeding the Nyquist frequency vn = 1/(2 x 2P) of the focus detection system is not completely absent. Consequently the phase of the object image may not be fully reflected in the phase of the signals depending on the pattern on the object, so that the result of focus detection may include a certain error.

However, if the images do not have a phase difference, the above-mentioned fact does not lead to the error in the focus detection, since the error in phase is evenly added to the paired signals. Thus the signals as shown in Fig. 23 or 24 do not give rise to an error in the focus detection, but those as shown in Fig. 19 or 20 result in an error in the detection of the defocus amount.

As will be understood from Fig. 18, the sampling positions for the object image for the signals 86, 87 are displaced by a half pitch from those for the signals 84, 85, so that it is rendered possible to reduce the error in the focus detection and to avoid the aforementioned drawback by averaging the result of focus detection derived from the signals 84, 85 and that derived from the signals 86, 87 to obtain the final result of focus detection.

Similarly the sampling positions for the object image for the signals 90, 91 are displaced by a half pitch from those for the signals 88, 89, so that it is rendered possible to reduce the error in the focus detection by averaging the result of focus detection derived from the signals 88, 89 and that derived from the signals 90, 91 to obtain the final result of focus detection. In such case, the results of the focus detections based principally on red color and blue color are averaged, and such averaging is desirable since it also averages the color aberration of the image pickup optical system 24.

It is also possible to obtain a higher accuracy for detecting the end point by selecting and averaging the results of higher reliability among the result of focus detection derived from the signals 84, 85, that from the signals 86, 87, that from the signals 88, 89 and that from the signals 90, 91. For example, the result of focus detection based on the signals of low contrast as shown in Fig. 21 or 22 may be excluded from the focusing.

In the foregoing description, it is assumed that the signal of the first photoelectric conversion unit and that of the second photoelectric conversion unit are mutually shifted only in the phase. Such assumption stands only when the defocus amount is relatively small. In the following there will be explained a process in case of a large defocus amount.

In the image pickup apparatus shown in Fig. 27, the diaphragm stop ST is provided with five apertures 204 to 208, among which the apertures 204 to 206 are used for image pickup while those 207, 208 are used for detecting a large defocus amount. In the image pickup operation, one of the apertures 204 to 206 is automatically selected according to the luminance of the object to be picked up. Otherwise the user may arbitrarily select one of the apertures 204 to 206. With a reduction of the size of the aperture, namely with a shift from the aperture 204 to 205 or from 205 to 206, the focused range in the object field becomes wider and the charge accumulating time by the electronic shutter becomes longer.

The microlens provided on the image sensor element projects each light-receiving unit thereof onto the exit pupil of the image pickup optical system 24, and has such a power that the projected image of each light-receiving unit becomes larger than the exit pupil of the image pickup optical system when the diaphragm stop thereof is fully open, in order to establish a linear relationship between the light amount entering each light-receiving unit of the image sensor element 100 and the aperture of the diaphragm stop ST. Thus, on the diaphragm stop ST, the projected image of the light-receiving unit is even larger than the largest aperture 204. In this manner the incident light amount to the image sensor element becomes approximately proportional to the area of the aperture of the diaphragm stop, whereby the diaphragm stop value and the shutter speed can be calculated by a method similar to that in the conventional camera when the luminance of the object and the sensitivity of the image sensor element are given. Stated differently, the incident light amount becomes proportional to the area of the aperture of the diaphragm stop and there stands the calculation by the APEX method.

As already explained with reference to Fig. 28, in the image pickup operation with any of the apertures 204, 205 and 206, each image is formed by a half light beam of a semicircular shape. In general, the object image is given by the convolution of a point image and the luminance pattern of the object, but, when the object image is significantly defocused, the shape of the exit pupil appears on the point image. As a result, the image is superposed with a blur of a semicircular shape.

If the paired images for focus detection are formed respectively through a pair of exit pupils which can be mutually matched by parallel displacement, the signal of the first photoelectric conversion unit and that of the second photoelectric conversion unit are shifted only in the phase, regardless of the shape of each exit pupil. In the present image pickup apparatus, however, the first area 211 and the second area 212 on the exit pupil are mutually inverted and cannot be matched by the parallel displacement. Consequently the shapes of the blurs superposed with the images are similarly mutually inverted, so that the signal of the first photoelectric conversion unit and that of the second photoelectric conversion unit are not only shifted in phase but also are different in the shape. Therefore, in case of a large defocus amount, the detection of the phase difference of the images cannot be executed properly, resulting in a large detection error for the defocus amount.

Also in case of a large defocus amount, the detection error for the defocus amount is also increased by the error in the manufacture of the microlenses. As explained in the foregoing, the microlenses project the light-receiving units onto the exit pupil of the image pickup optical system. If the projected positions fluctuate among the pixels, the amount of phase shift in the defocus state fluctuates from pixel to pixel. This influence becomes larger as the defocus amount becomes larger. However, as the microlenses are very small, a certain fluctuation in the manufacture has to be tolerated in practice.

Therefore, in case of detecting a large defocus, there are employed the apertures 207, 208 of the diaphragm stop ST therefor. In this case, the exit pupil is divided as shown in Fig. 29, in which 210, 214 are false images of the apertures 207, 208 seen through the rear lens group 202 and constitute third and fourth areas formed by the apertures 207, 208 on the exit pupil.

The third area 213 is included in the first area 211, while the fourth area 214 is included in the second area 212, so that the apertures 207, 208 determine the shape of the exit pupil. The first photoelectric conversion unit receives the light beam passing through the aperture 207, and the second photoelectric conversion unit receives the light beam passing through the aperture 208.

The first and second areas 211, 212 are affected by the precision of projection by the microlenses, but the third and fourth areas 213, 214 are not affected. Consequently, even if the positions of the first and second areas 211, 212 fluctuate from pixel to pixel by the manufacturing error of the microlenses, the third and fourth areas 213, 214 can be obtained in fixed positions by the use of the apertures 207, 208.

If the apertures 207, 208 are formed for example as a circle or an oval, which can be matched by parallel displacement, the signals of the first and second photoelectric conversion units are mutually different only in the phase shift and are free from the influence of the manufacturing error of the microlenses. It is therefore possible, even for a large defocus amount, to suppress the detection error of the defocus amount to a very small amount. Also by selecting the incident height of the center of gravity of the apertures 207, 208 at about 0.7 times of the fully open diameter of the diaphragm, the defocus amount to the best focus position, in the image pickup optical system with a usual spherical aberration, can be detected with a precision in the level of such aberration.

With the zooming operation of the image pickup optical system 24 by the axial movement of the second and fourth groups, the fully open F-number is generally changed but the centers of gravity of the apertures 207, 208 with respect to the fully open diaphragm stop maintain a constant ratio, so that the incident height of the centers of gravity of the apertures 207, 208 is advantageously maintained at about 0.7 times of the fully open diameter of the diaphragm stop regardless of the zooming position.

The operation sequence of the image pickup apparatus is preferably so constructed as to use the apertures 207, 208 in the initial focus adjusting operation where the probability of focusing to the object is low, thereby executing focus adjustment capable of responding even to a large defocus amount and monitor display for observing the object, and to use any of the apertures 204, 205 and 206 in the second and subsequent focusing operation for executing the remaining the focus adjustment and the monitor display and for preparation for the succeeding image pickup operation.

As the present image pickup apparatus does not require the focus detecting device exclusive for detecting the defocus amount of the image pickup optical system, there can be dispensed with mirrors and prisms for splitting the optical path. Therefore the image pickup system can be made compact.

In the following there will be explained a second embodiment of the present invention.

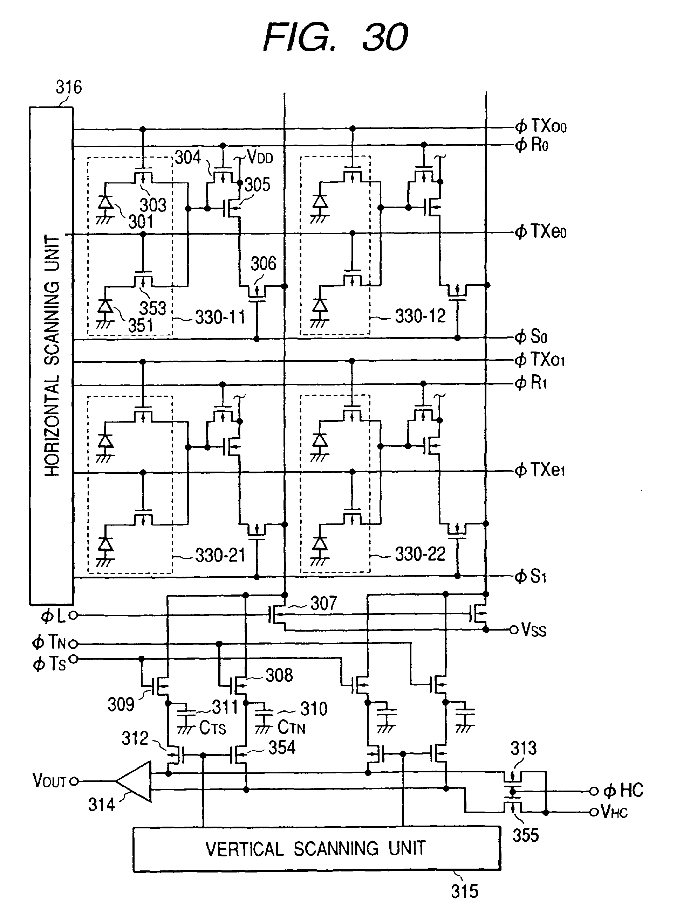

Fig. 30 is a circuit diagram of the area sensor unit of the present embodiment. The present embodiment is same as the first embodiment except that the photoelectric conversion unit is not provided with the photogates but with pn photodiodes.

The charges of the two photoelectric conversion units can be simultaneously or independently transferred to the floating diffusion (FD) area, and can be added or not added solely by the timing of the transfer MOS transistor connected to the FD area. Such configuration is utilized for switching the first operation mode for receiving the light beam from the entire exit pupil of the image pickup lens between the second operation mode for receiving the light beam from a part of the exit pupil.

Referring to Fig. 30, there are shown first and second photoelectric conversion units 301, 351 consisting of pn photodiodes; transfer switch MOS transistors 303, 353; a resetting MOS transistor 304; a source-follower amplifier MOS transistor 305; a vertical selection switch MOS transistor 306; a source-follower load MOS transistor 307; a dark output transfer MOS transistor 308; a light output transfer MOS transistor 309; a dark output accumulating capacitance C_{TN}310; a light output accumulating capacitance C_{TS}311; vertical transfer MOS transistors 312, 354; vertical output line resetting MOS transistors 313, 355; a differential output amplifier 314; a vertical scanning unit 315; and a horizontal scanning unit 316.

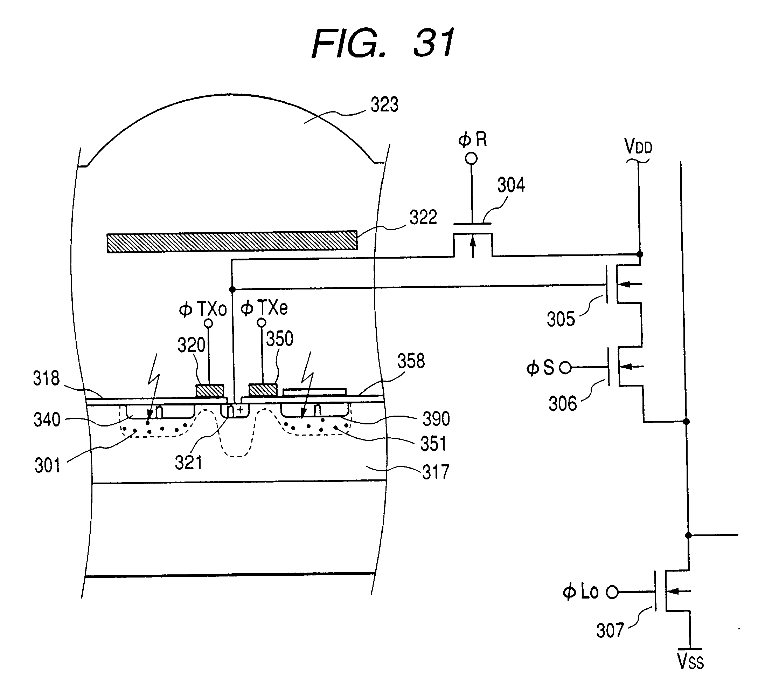

Fig. 31 is a cross-sectional view of a light-receiving unit (for example 330-11). The light-receiving units 330-21, 330-12, 330-22 have the same structure.

In Fig. 31, there are shown a p-well 317, gate oxide films 318, 358, polysilicon layers 320, 350, and an n⁺-floating diffusion area 321.

340 and 390 indicate n-layers of a concentration that can be completely depleted. The FD area 321 is connected to the first and second photoelectric conversion units 301, 351 through the transfer MOS transistors 303, 353. A control pulse φTX causes the complete transfer of the generated charges to the FD area 321 and allows to achieve addition or non-addition of the signals. The first photoelectric conversion unit 301 and the second photoelectric conversion unit 351 are mutually separate in Fig. 31, but the boundary therebetween is extremely small so that the first photoelectric conversion unit 301 and the second photoelectric conversion unit 351 can be regarded as mutually adjacent in practice.

There are also shown a color filter 322 for transmitting the light of a specified wavelength region, and a microlens 323 for efficiently guiding the light from the image pickup optical system 24 to the first and second photoelectric conversion units.

In the following there will be explained the charge accumulating operation of the image sensor element. At first, in order to prevent the blooming phenomenon, the FD area 321 is fixed at the power supply voltage V₀₀ by setting the control pulse φR₀ at the high level state during the accumulating operation. Under the irradiation with photons hv, the electrons are accumulated in the pn photodiodes 301, 351 while the positive holes are discharged through the P-well 317.

Energy barriers are formed between the photoelectric conversion unit 301 and the FD area 321 by the transfer MOS transistor 303 and between the photoelectric conversion unit 351 and the FD area 321 by the transfer MOS transistor 353. Therefore the electrons remain in the pn photodiodes 301, 353 during the photocharge accumulation. The charge accumulation is achieved in all the photoelectric conversion units by a similar charge accumulating operation through the scanning operation of the horizontal scanning unit.

In the charge readout state, the control pulses φTX₀₀, φTXₑ₀ are so set as to eliminate the barrier under the transfer MOS transistor 303 or 353 thereby completely transferring the electrons of the pn photodiodes 301, 351 to the FD area 321.

The focus detecting images obtained by the second light-receiving mode for independently outputting the charges of the two photoelectric conversion units can be read out by employing the control pulses shown in Fig. 16, excluding however φPG₀₀ and φPGₑ₀.

At first, a control pulse φR₀ is shifted to the high level state to reset the FD area 321 to the power supply voltage V_{DD}. Also a control pulse φS₀ is shifted to the high level state to accumulate the dark output in the dark output accumulating capacitance 310, and a control pulse φTX₀₀ is shifted to the high level state to transfer the photocharge accumulated in the pn photodiode 301 to the accumulating capacitance 311 through the source-follower MOS transistor 305 and the selection switch MOS transistor 306, while the noise component is canceled by the differential amplifier 314 whereby outputted is the image signal V_{OUT} of the first photoelectric conversion unit.

Then, the control pulse φR₀ is shifted to the high level state to reset the FD area 321 to the power supply voltage V_{DD}. Also the control pulse φTXₑ₀ is shifted to the high level state to transfer the photocharge accumulated in the pn photodiode 351 to the accumulating capacitance 311 through the source-follower MOS transistor 305 and the selection switch MOS transistor 306, while the noise component is canceled by the differential amplifier 314 whereby outputted is the image signal V_{OUT} of the second photoelectric conversion unit.

Also the focus detecting images obtained by the first light-receiving mode for adding the charges of the two photoelectric conversion units can be read out by employing the control pulses shown in Fig. 17, excluding however φPG₀₀ and φPGₑ₀.

In the following there will be explained a third embodiment of the present invention.

In contrast to the first and second embodiments in which a source-follower amplifier MOS transistor is provided for two photoelectric conversion units and the charges are added in the floating diffusion area, the present embodiment is featured by a configuration in which a source-follower amplifier MOS transistor is provided for one photoelectric conversion unit and the charges are added outside the pixel area.

Two capacitances 401, 402 are provided for each column, and the signals from the capacitances 401, 402 are simultaneously outputted to an output line 405 and are added by a pulse output simultaneous to transistors 403, 404 from a vertical shift register. Also pixel-by-pixel output is achieved by successive pulse outputs to the transistors 403, 404.

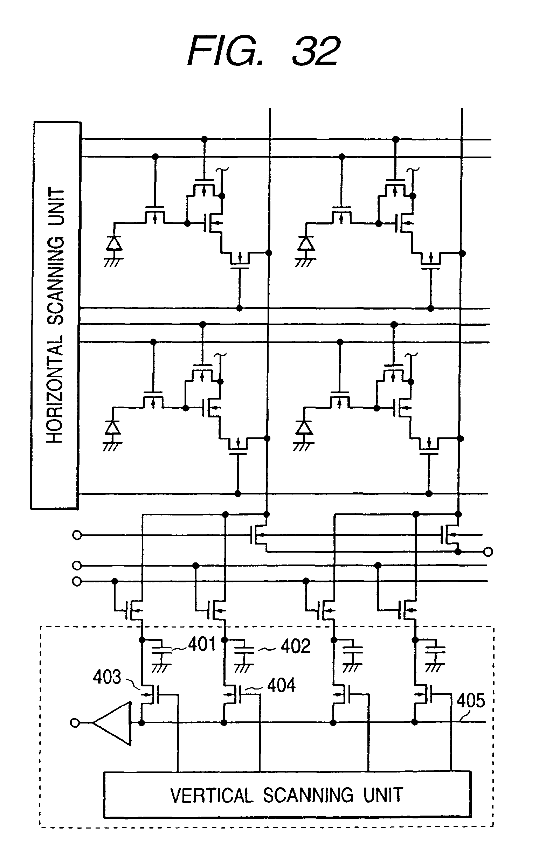

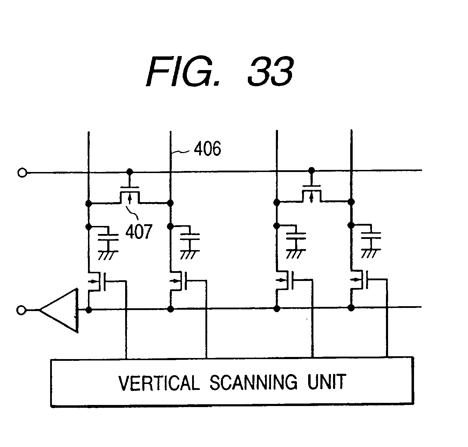

Fig. 33 shows another circuit configuration of a broken-lined area in Fig. 32. As shown in Fig. 33, the addition or non-addition of the signals may be achieved by on/off state of a transistor 407 provided on the output line 406.

In the following there will be explained a fourth embodiment of the present invention.

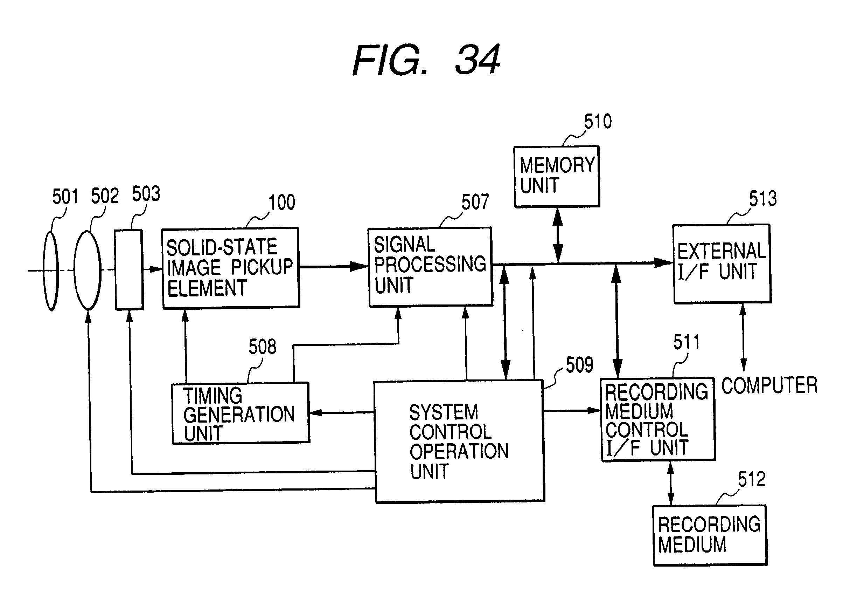

In the following there will be explained, with reference to Fig. 34, an application of the image sensor element of the aforementioned first or second embodiment to an image pickup apparatus such as a still camera.

In Fig. 34 there are shown a barrier 501 for protecting the lens and serving as a main switch; a lens 502 for focusing an optical image of the object on the image sensor element 100; a diaphragm 503 for varying the amount of light passed by the lens 502; an image sensor element 100 for fetching the object, focused by the lens 502, as an image signal; a timing generation unit 508 for supplying the image sensor element 100 and a signal processing unit 507 with various timing signals; a control/operation unit 509 for executing various calculations and controlling the entire image pickup apparatus; a memory unit 510 for temporarily storing the image data; an interface unit 511 for executing storage in or readout from a recording medium; a detachable recording medium 512 such as a semiconductor memory for storage or readout of the image data; and an interface unit 513 for communication with an external computer or the like.

In the following there will be explained the function of the image pickup apparatus of the aforementioned configuration in the image pickup operation.

When the barrier 501 is opened, the main power supply is turned on, and the power supply for the control system is then turned on. Then, for controlling the exposure amount, the control/operation unit 509 opens the diaphragm 503, and the signal outputted from the image sensor element 504 is supplied to the signal processing unit 507. Based on such data, the control/operation unit 509 calculates the exposure. The luminance is judged from the result of such light metering, and the control/operation unit 509 controls the diaphragm based on its result.

Then the high frequency component is extracted from the non-added signals obtained from the image sensor element 100 as explained in the foregoing first and second embodiments, and the control/operation unit 509 calculates the distance to the object. Thereafter the lens is driven and there is judged whether the in-focus state is reached, and, if not, the lens is driven again and the distance is measured.

The main exposure is started after the in-focus state is confirmed. After the exposure, the added signal obtained from the image sensor element 100 as explained in the foregoing first and second embodiments is subjected to color correction etc. in the signal processing unit 507 and is stored in the memory unit by the control/operation unit 509. Thereafter the data stored in the memory unit 510 are transmitted, under the control of the control/operation unit 509, by the recording medium control interface unit and are recorded in the detachable recording medium 512 such as a semiconductor memory. They may also be directly entered for example into a computer through the external interface unit 513 for image processing.

In the foregoing first to third embodiments, the addition of the signals from the photoelectric conversion units is executed in the image sensor element, but such addition may also be executed outside the image sensor element, for example in a signal processing unit 507, as shown in Fig. 34.

As explained in the foregoing, the first to third embodiments enable prompt adjustment for the image pickup operation and allow to form an image of high image quality. Also they enable focus detection of the phase difference detection method by the image sensor element, thereby realizing prompt focus adjustment based on the detected defocus amount.

Also there can be obtained a high quality image excellent in S/N ratio, comparable to the image obtained by an image sensor element so designed as to obtain the image utilizing the light beam coming from the entire pupil of the image pickup optical system. In addition, there is not generated unnatural image blur in the image.

Also as the focus detecting device exclusive for detecting the defocus amount of the image pickup optical system is not required, there can be dispensed with the mirrors and prisms for splitting the optical path. Consequently the image pickup system can be made compact.

Many widely different embodiment of the present invention may be constructed without departing from the scope of the present invention. It should be understood that the present invention is not limited to the specific embodiments described in the specification, except as defined in the appended claims.

## Claims

1. An image pickup apparatus (100) comprising:
a plurality of pixels (30-11, 30-12, ..., 30-22; 70-11, ..., 70-44), each of which has:
a first photoelectric conversion unit (1) for photoelectrically converting a light beam from a first half (211; 213) of an exit pupil (210) into an electrical signal,
a second photoelectric conversion unit (51) for photoelectrically converting a light beam from a second half (212; 214) of said exit pupil (210) into an electrical signal, and
a colour filter (22) for transmitting light of a specified wavelength region to the first and second photoelectric conversion units (1, 51);
a control unit (101, 103, 104, 3, 53) for obtaining a first signal and a second signal from each pixel, wherein the first signal includes separately the electrical signal obtained by said first photoelectric conversion unit (1) thereof and the electrical signal obtained by said second photoelectric conversion unit (51) thereof, and the second signal is a sum signal corresponding to the addition of the electrical signal obtained by said first photoelectric conversion unit (1) and the electrical signal obtained by said second photoelectric conversion unit (51); and
process means (105-107; 507) arranged to execute focus adjustment on the basis of phase difference between the signals outputted respectively from said first and second photoelectric conversion units (1, 51) and to subject the sum signal to colour correction to execute image forming processing;
wherein:
said first and second photoelectric conversion units (1, 51) are arranged in a direction in which said exit pupil is divided into the first and second halves;
focus detection areas (61 to 67) are oblong in a direction in which said exit pupil is divided into the first and second halves, each of which comprises two sets of pixel columns (82, 83) in which the colour filters (22) of different kinds are alternately arranged in a Bayer arrangement; and each pixel includes amplification means (5) arranged to amplify and output the signals from said first and second photoelectric conversion units (1, 51), wherein the signals from said first and second photoelectric conversion units are added at an input (21) of said amplification means (5),
wherein said process means (105-107; 507) are arranged, for focus adjustment, to divide each pixel column into groups according to the kinds of the colour filters, to generate, from each divided groups, pairs of image signals consisting of the signals from the first photoelectric conversion means (1) and from the second photoelectric conversion means (51), and to average respective pairs of image signals.

2. The apparatus according to claim 1, wherein at each respective pixel (70-11; ....; 70-44) said first and second photoelectric conversion units (72-11; ....; 72-44) are arranged under a same respective microlens (71-11; ....; 71-44) .

3. The apparatus according to claim 2, further comprising:
an output line for outputting the signal from a plurality of said amplification means (5),
wherein said first and second photoelectric conversion units (1, 51: 72-11, ..., 72-44), arranged under a same respective microlens (71-11, ..., 71-44), and said amplification means (5) are arranged two-dimensionally, and
wherein said first and second photoelectric conversion units, said amplification means, said output line and said microlenses are formed on a single semiconductors substrate (17).

4. An image pickup apparatus according to claim 3, further comprising:
readout means (15, 16; 101, 103, 104; 315, 316) for controlling a mode for independently reading the signals from said first and second photoelectric conversion units (1, 51) from said amplification means (5) and a mode for reading the signals from said first and second photoelectric conversion units by adding at an input unit (21) of said amplification means; and
wherein said readout means is provided on said single semiconductor substrate (17).

## Patentansprüche

1. Bildaufnahmevorrichtung (100) mit:
einer Vielzahl von Bildelementen (30-11, 30-12, ..., 30-22; 70-11, ..., 70-44), wobei jedes von diesen aufweist:
eine erste photoelektrische Wandlungseinheit (1) zum photoelektrischen Wandeln eines Lichtstrahls von einer ersten Hälfte (211; 213) einer Austrittspupille (210) in ein elektrisches Signal,
eine zweite photoelektrische Wandlungseinheit (51) zum photoelektrischen Wandeln eines Lichtstrahls von einer zweiten Hälfe (212; 214) der Austrittspupille (210) in ein elektrisches Signal, und
ein Farbfilter (22) zum Übertragen von Licht eines bestimmten Wellenlängenbereichs an die erste und die zweite photoelektrische Wandlungseinheit (1, 51);
einer Steuereinheit (101, 103, 104, 3, 53) zum Erhalten eines ersten Signals und eines zweiten Signals von jedem Bildelement, wobei das erste Signal das durch die erste photoelektrische Wandlungseinheit (1) von diesem erhaltene elektrische Signal und das durch die zweite photoelektrische Wandlungseinheit (51) von diesem erhaltene elektrische Signal separat umfasst, und das zweite Signal ein Summensignal ist, das der Addition des durch die erste photoelektrische Wandlungseinheit (1) erhaltenen Signals und des durch die zweite photoelektrische Wandlungseinheit (51) erhaltenen Signals entspricht; und
Verarbeitungseinrichtungen (105 bis 107; 507), die eingerichtet sind, eine Fokusanpassung auf Grundlage einer Phasendifferenz zwischen den Signalen auszuführen, die jeweils von der ersten und der zweiten photoelektrischen Wandlungseinheit (1, 51) ausgegeben werden, und das Summensignal einer Farbkorrektur zu unterziehen, um eine Bilderzeugungsverarbeitung auszuführen;
wobei:
die erste und die zweite photoelektrische Wandlungseinheit (1, 51) in einer Richtung eingerichtet sind, in der die Austrittspupille in die erste und die zweite Hälfte unterteilt ist;
Fokuserfassungsbereiche (61 bis 67) länglich in einer Richtung sind, in der die Austrittspupille in die erste und die zweite Hälfte unterteilt ist, wobei jeder von diesen zwei Sätze von Bildelementspalten (82, 83) aufweist, in denen die Farbfilter (22) unterschiedlicher Arten in einer Bayer-Anordnung abwechselnd angeordnet sind; und
jedes Bildelement eine Verstärkungseinrichtung (5) umfasst, die eingerichtet ist, die Signale von der ersten und der zweiten photoelektrischen Wandlungseinheit (1, 51) zu verstärken und auszugeben, wobei die Signale von der ersten und der zweiten photoelektrischen Wandlungseinheit an einem Eingang (21) der Verstärkungseinrichtung (5) addiert werden,
wobei die Verarbeitungseinrichtungen (105 bis 107; 507) eingerichtet sind, zur Fokusanpassung jede Bildelementspalte in Gruppen gemäß den Arten der Farbfilter zu unterteilen, aus jeder unterteilten Gruppe Paare von Bildsignalen zu erzeugen, die aus den Signalen von der ersten photoelektrischen Wandlungseinheit (1) und von der zweiten photoelektrischen Wandlungseinheit (51) bestehen, und jeweilige Paare von Bildsignalen zu mitteln.

2. Vorrichtung gemäß Anspruch 1, wobei bei jedem jeweiligen Bildelement (70-11; ...; 70-44) die erste und die zweite photoelektrische Wandlungseinheit (72-11; ...; 72-44) unter einer jeweils gleichen Mikrolinse (71-11; ...; 71-44) angeordnet sind.

3. Vorrichtung gemäß Anspruch 2, zusätzlich mit:
einer Ausgabeleitung zum Ausgeben des Signals von einer Vielzahl der Verstärkungseinrichtungen (5),
wobei die erste und die zweite photoelektrische Wandlungseinheit (1, 51; 72-11, ..., 72-44), die unter einer jeweils gleichen Mikrolinse (71-11, ..., 71-44) angeordnet sind, und die Verstärkungseinrichtungen (5) zweidimensional angeordnet sind, und
wobei die erste und zweite photoelektrische Wandlungseinheit, die Verstärkungseinrichtungen, die Ausgabeleitung und die Mikrolinsen auf einem einzigen Halbleitersubstrat (17) ausgebildet sind.

4. Bildaufnahmevorrichtung gemäß Anspruch 3, zusätzlich mit:
einer Ausleseeinrichtung (15, 16; 101, 103, 104; 315, 316) zum Steuern eines Modus zum unabhängigen Lesen der Signale von der ersten und der zweiten photoelektrischen Wandlungseinheit (1, 51) aus den Verstärkungseinrichtungen (5) und eines Modus zum Lesen der Signale von der ersten und der zweiten photoelektrischen Wandlungseinheit durch Addition an einer Eingangseinheit (21) der Verstärkungseinrichtungen; und
wobei die Ausleseeinrichtung auf dem einzigen Halbleitersubstrat (17) bereitgestellt ist.

## Revendications

1. Dispositif (100) d'acquisition d'image comprenant :
une pluralité de pixels (30-11, 30-12, ..., 30-22 ; 70-11, ..., 70-44) , dont chacun comporte :
une première unité (1) de conversion photoélectrique destinée à convertir de façon photoélectrique, en un signal électrique, un faisceau de lumière provenant d'une première moitié (211 ; 213) d'une pupille de sortie (210),
une seconde unité (51) de conversion photoélectrique destinée à convertir de façon photoélectrique, en un signal électrique, un faisceau de lumière provenant d'une seconde moitié (212 ; 214) de ladite pupille de sortie (210),
un filtre (22) de couleur destiné à transmettre de la lumière d'une région spécifiée de longueur d'onde aux première et seconde unités (1, 51) de conversion photoélectrique ;
une unité (101, 103, 104, 3, 53) de commande destinée à obtenir un premier signal et un second signal de chaque pixel, dans lequel le premier signal inclut séparément le signal électrique obtenu par ladite première unité (1) de conversion photoélectrique de celui-ci et le signal électrique obtenu par ladite seconde unité (51) de conversion électrique de celui-ci, et dans lequel le second signal est un signal somme correspondant à l'addition du signal électrique obtenu par ladite première unité (1) de conversion photoélectrique et du signal électrique obtenu par ladite seconde unité (51) de conversion photoélectrique ; et
des moyens (105 à 107 ; 507) de traitement agencés pour exécuter un ajustement de mise au point sur la base de la différence de phase entre les signaux sortis respectivement desdites première et seconde unités (1, 51) de conversion photoélectrique et pour soumettre le signal somme à une correction de couleur pour exécuter un traitement de formation d'image,
dans lequel :
lesdites première et seconde unités (1, 51) de conversion photoélectrique sont agencées dans la direction dans laquelle ladite pupille de sortie est divisée en les première et seconde moitiés ; des zones (61 à 67) de détection de mise au point sont oblongues dans la direction dans laquelle ladite pupille de sortie est divisée en les première et seconde moitiés, dont chacune comprend deux ensembles de colonnes de pixels (82, 83) où des filtres (22) de couleur de différentes sortes sont agencés de manière alternée dans un agencement de Bayer ; et chaque pixel inclut un moyen (5) d'amplification agencé pour amplifier et sortir les signaux issus desdites première et seconde unités (1, 51) de conversion photoélectrique, les signaux desdites première et seconde unités de conversion photoélectrique étant additionnés au niveau d'une entrée (21) dudit moyen (5) d'amplification,
dans lequel lesdits moyens (105 à 107 ; 507) de traitement sont agencés, pour ajustement de mise au point, de façon à diviser chaque colonne de pixels en groupes en fonction des sortes de filtres de couleur, à engendrer, à partir de chaque groupe obtenu par division, des paires de signaux d'image constituées des signaux issus du premier moyen (1) de conversion photoélectrique et du second moyen (51) de conversion photoélectrique, et à faire la moyenne des paires respectives de signaux d'image.

2. Dispositif selon la revendication 1, dans lequel, au niveau de chaque pixel respectif (70-11 ; ... ; 70-44), lesdites première et seconde unités (72-11 ; ... ; 72-44) de conversion photoélectrique sont agencées sous une même microlentille respective (71-11 ; ... ; 71-44).

3. Dispositif selon la revendication 2, comprenant en outre :
une ligne de sortie destinée à sortir le signal issu d'une pluralité desdits moyens (5) d'amplification,
dans lequel lesdites première et seconde unités (1, 51 ; 72-11, ..., 72-44) de conversion photoélectrique, agencées sous la même microlentille respective (71-11, ..., 71-44), et lesdits moyens (5) d'amplification sont agencés de façon bidimensionnelle, et
dans lequel lesdites première et seconde unités de conversion photoélectrique, lesdits moyens d'amplification, ladite ligne de sortie et lesdites microlentilles sont formés sur un unique substrat (17) à semi-conducteurs.

4. Dispositif d'acquisition d'image selon la revendication 3, comprenant en outre :
un moyen (15, 16 ; 101, 103, 104 ; 315, 316) de lecture destiné à commander un mode pour lire indépendamment les signaux provenant desdites première et seconde unités (1, 51) de conversion photoélectrique issus dudit moyen (5) d'amplification et un mode pour lire les signaux provenant desdites première et seconde unités de conversion photoélectrique par addition au niveau d'une unité (21) d'entrée dudit moyen d'amplification ; et
dans lequel ledit moyen de lecture est disposé sur ledit unique substrat (17) à semi-conducteurs.
